# EUROPEAN PATENT APPLICATION

(11) **EP 4 572 556 A1**
(43) Date of publication of application: **18.06.2025**
(21) Application number: 24212639.9
(22) Date of filing: 13.11.2024
(51) Int. Cl.: H10B 12/00

(54) **SEMICONDUCTOR MEMORY DEVICES**

(30) Priority: 23.11.2023 KR 20230164494
(71) Applicant: Samsung Electronics Co., Ltd., Suwon-si, Gyeonggi-do 16677 (KR)
(72) Inventor: LEE, Yanghee, 16677 Suwon-si (KR); KIM, Seongeun, 16677 Suwon-si (KR); KANG, Seungji, 16677 Suwon-si (KR); KIM, Hyukmin, 16677 Suwon-si (KR); PARK, Jonghyuk, 16677 Suwon-si (KR); BAE, Jinwoo, 16677 Suwon-si (KR); LEE, Dongwon, 16677 Suwon-si (KR); HAN, Juyeon, 16677 Suwon-si (KR)
(74) Representative: Marks & Clerk LLP

(57) **Abstract**

A semiconductor memory device includes a substrate; a capacitor structure that includes a lower electrode on the substrate, a capacitor dielectric layer on the lower electrode, and an upper electrode on the capacitor dielectric layer; a charge insulation layer on the capacitor structure; and a wiring contact plug that extends in the charge insulation layer and is electrically connected to the upper electrode, wherein the upper electrode includes a first upper electrode layer on the capacitor dielectric layer, a second upper electrode layer on the first upper electrode layer, and a third upper electrode layer on the second upper electrode layer, and wherein the first upper electrode layer includes a first semiconductor material, the second upper electrode layer includes a metal-group material, and the third upper electrode layer includes a second semiconductor material.

## Description

### BACKGROUND OF THE INVENTION

The inventive concept relates to semiconductor memory devices, and more particularly, to semiconductor memory devices including a capacitor structure.

As the electronics industry advances rapidly and the demands of users increases, electronic devices are being miniaturized further and becoming more multifunctional. Therefore, semiconductor memory devices used in electronic devices need a high degree of integration, and thus, the design rule of elements of semiconductor memory devices has been reduced. Due to this, it may be difficult to secure the reliability of semiconductor memory devices and the level of difficulty of a process of forming semiconductor memory devices is increasing.

### SUMMARY OF THE INVENTION

The inventive concept provides a semiconductor memory device including a capacitor structure, in which reliability is secured and the level of difficulty of a process of forming semiconductor memory devices is reduced.

A semiconductor memory device according to an embodiment includes a substrate; a capacitor structure that includes a lower electrode on the substrate, a capacitor dielectric layer on the lower electrode, and an upper electrode on the capacitor dielectric layer; a charge insulation layer on the capacitor structure; and a wiring contact plug that extends in the charge insulation layer and is electrically connected to the upper electrode, wherein the upper electrode includes a first upper electrode layer on the capacitor dielectric layer, a second upper electrode layer on the first upper electrode layer, and a third upper electrode layer on the second upper electrode layer, and wherein the first upper electrode layer includes a first semiconductor material, the second upper electrode layer includes a metal-group material, and the third upper electrode layer includes a second semiconductor material. The first upper electrode layer may consist of a first semiconductor material. The second upper electrode layer may consist of a metal-group material. The third upper electrode layer may consist of a second semiconductor material.

A semiconductor memory device according to an embodiment includes a substrate including a memory cell region, wherein the memory cell region includes a plurality of active regions; a plurality of word lines extending in a first horizontal direction, wherein the plurality of word lines overlaps the plurality of active regions in a vertical direction; a plurality of bit lines on the plurality of active regions, wherein the plurality of bit lines extends in a second horizontal direction that is perpendicular to the first horizontal direction; a plurality of buried contacts, wherein each of the plurality of buried contacts is in contact with a corresponding one of the plurality of active regions and is in a lower portion of a space between adjacent bit lines among the plurality of bit lines; a plurality of landing pads, wherein each of the plurality of landing pads is in an upper portion of the space between the adjacent bit lines among the plurality of bit lines and overlaps one of the adjacent bit lines among the plurality of bit lines in the vertical direction; a plurality of capacitor structures including a plurality of lower electrodes that are electrically connected to the plurality of landing pads, respectively, a capacitor dielectric layer on the plurality of lower electrodes, and an upper electrode on the capacitor dielectric layer; and a charge insulation layer on the plurality of capacitor structures, wherein the first horizontal direction and the second horizontal direction are parallel with a lower surface of the substrate, wherein the vertical direction is perpendicular to the lower surface of the substrate, wherein the upper electrode includes a first upper electrode layer on the capacitor dielectric layer, a second upper electrode layer on the first upper electrode layer, and a third upper electrode layer on the second upper electrode layer, wherein the first upper electrode layer includes a semiconductor material, wherein the second upper electrode layer includes a metal, and wherein the third upper electrode layer includes the semiconductor material. The first upper electrode layer may consist of a semiconductor material. The second upper electrode layer may consist of a metal. The third upper electrode layer may consist of the semiconductor material. The plurality of buried contacts may be located in a lower portion (e.g., in the vertical direction) of a space between adjacent bit lines among the plurality of bit lines. Each of the plurality of landing pads may be located in an upper portion (e.g., in the vertical direction relative to the lower portion) of a space between adjacent bit lines among the plurality of bit lines. The lower and upper portions may be contiguous in the vertical direction.

A semiconductor memory device according to an embodiment includes a substrate including a memory cell region and a periphery region, wherein the memory cell region includes a plurality of active regions, and the periphery region includes at least one logic active region; a gate line on the at least one logic active region; a logic bit line on the gate line; a plurality of word lines extending in a first horizontal direction, wherein the plurality of word lines overlaps the plurality of active regions in a vertical direction; a plurality of bit lines on the plurality of active regions, wherein the plurality of bit lines extends in a second horizontal direction that is perpendicular to the first horizontal direction; a plurality of buried contacts that is in contact with the plurality of active regions, and wherein one of the plurality of buried contacts is in a lower portion of a space between adjacent bit lines among the plurality of bit lines; a plurality of landing pads, wherein one of the plurality of landing pads is in an upper portion of the space between the adjacent bit lines among the plurality of bit lines and overlaps one of the adjacent bit lines among the plurality of bit lines in the vertical direction, and wherein at least a portion of each of the plurality of landing pads is at a same height as the logic bit line in the vertical direction; a plurality of capacitor structures including a plurality of lower electrodes that are electrically connected to the plurality of landing pads, respectively, a capacitor dielectric layer on the plurality of lower electrodes, and an upper electrode on the capacitor dielectric layer; a charge insulation layer on the logic bit line and the plurality of capacitor structures; a plurality of wiring lines on the charge insulation layer; a first wiring contact plug that extends in the charge insulation layer, wherein a first wiring line of the plurality of wiring lines is electrically connected to the upper electrode through the first wiring contact plug; and a second wiring contact plug that extends in the charge insulation layer, wherein a second wiring line of the plurality of wiring lines is electrically connected to the logic bit line through the second wiring contact plug, wherein the upper electrode includes a first upper electrode layer on the capacitor dielectric layer, a second upper electrode layer on the first upper electrode layer, and a third upper electrode layer on the second upper electrode layer, wherein the first upper electrode layer includes poly silicon germanium, wherein the second upper electrode layer includes tungsten, wherein the third upper electrode layer includes poly silicon germanium, wherein the first horizontal direction and the second horizontal direction are parallel with a lower surface of the substrate, and wherein the vertical direction is perpendicular to the lower surface of the substrate. The first upper electrode layer may consist of poly silicon germanium. The second upper electrode layer may consist of tungsten. The third upper electrode layer may consist of poly silicon germanium. The plurality of buried contacts may be located in a lower portion (e.g., in the vertical direction) of a space between adjacent bit lines among the plurality of bit lines. One of the plurality of landing pads may be located in an upper portion (e.g., in the vertical direction relative to the lower portion) of a space between adjacent bit lines among the plurality of bit lines. The lower and upper portions may be contiguous in the vertical direction.

The semiconductor memory devices may not comprise an etch stop layer between the upper electrode (e.g., the third upper electrode layer) and the charge insulation layer or a component thereof. The semiconductor memory devices may not comprise an etch stop layer on the upper electrode (e.g., the third upper electrode layer) to form the charge insulation layer or a component thereof. In other words, the charge insulation layer may be directly on the upper electrode (e.g., the third upper electrode layer) with no intervening layers between. This may improve reliability and/or reduce the level of difficulty of a process of forming semiconductor memory devices.

At least some of the above and other features of the disclosure are set out in the claims.

### BRIEF DESCRIPTION OF THE DRAWINGS

Embodiments will be more clearly understood from the following detailed description taken in conjunction with the accompanying drawings in which:
FIG. 1 is a block diagram illustrating a semiconductor memory device according to example embodiments;
FIG. 2 is a schematic plan layout illustrating main elements of a semiconductor memory device according to example embodiments;
FIGS. 3A to 3F, 4A to 4F, 5A to 5F, 6A to 6F, 7A to 7F, 8A to 8F, 9A to 9F, 10A to 10F, 11A to 11C, 12A to 12C, 13A to 13C, 14A to 14C, and 15A to 15C are cross-sectional views illustrating a method of manufacturing a semiconductor memory device, according to example embodiments.
FIGS. 16A to 16C are cross-sectional views illustrating a semiconductor memory device according to example embodiments;
FIGS. 17A to 17C are enlarged cross-sectional views of a semiconductor memory device according to example embodiments;
FIG. 18 is a cross-sectional view illustrating a semiconductor memory device according to example embodiments;
FIG. 19 is a plan layout view illustrating a semiconductor memory device according to example embodiments, and FIG. 20 is a cross-sectional view taken along line X1-X1' and line Y1-Y1' of FIG. 19; and
FIG. 21 is a plan layout view illustrating a semiconductor memory device according to example embodiments, and FIG. 22 is a perspective view illustrating a semiconductor memory device according to example embodiments.

### DETAILED DESCRIPTION OF THE INVENTION

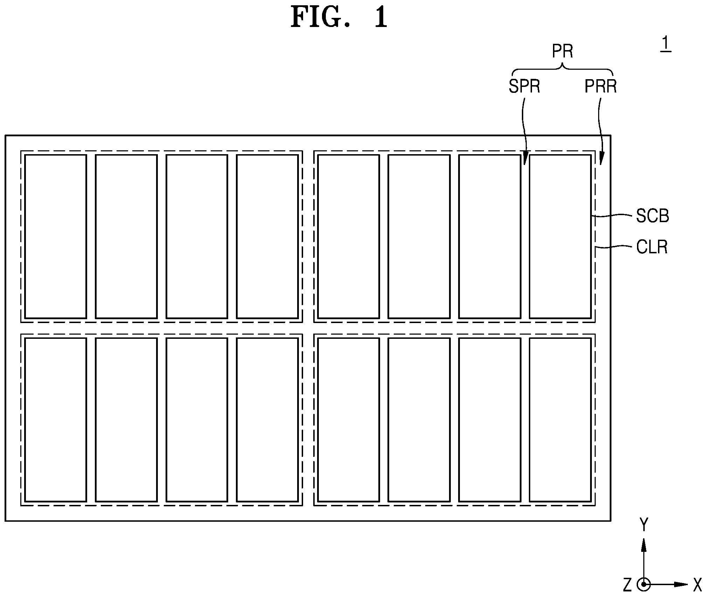

FIG. 1 is a block diagram for describing a semiconductor memory device 1 according to example embodiments.

Referring to FIG. 1, the semiconductor memory device 1 may include a cell region CLR where memory cells are disposed and a main periphery region PRR extending around (e.g., surrounding in a plan view) the cell region CLR. According to an embodiment, the cell region CLR may include sub periphery regions SPR, which divide cell blocks SCB. For example, the cell blocks SCB may be spaced apart from each other by the sub periphery regions SPR (in the plan view). A plurality of memory cells may be disposed in the cell blocks SCB. Herein, a cell block SCB may denote a region where the memory cells have a uniform interval and are regularly arranged, and the cell block SCB may be referred to as a sub cell block.

Logic cells for inputting or outputting an electrical signal to or from the memory cells may be disposed in the main periphery region PRR and the sub periphery region SPR. In some embodiments, the main periphery region PRR may include (or may be referred to as) a peripheral circuit region and the sub periphery region SPR may include (or may be referred to as) a core circuit region. A periphery region PR may include the main periphery region PRR and the sub periphery regions SPR. That is, the periphery region PR may include the peripheral circuit region and the core circuit region. In some embodiments, at least a portion of the sub periphery region SPR may be provided as only a space (without the core circuit region) dividing the cell blocks SCB.

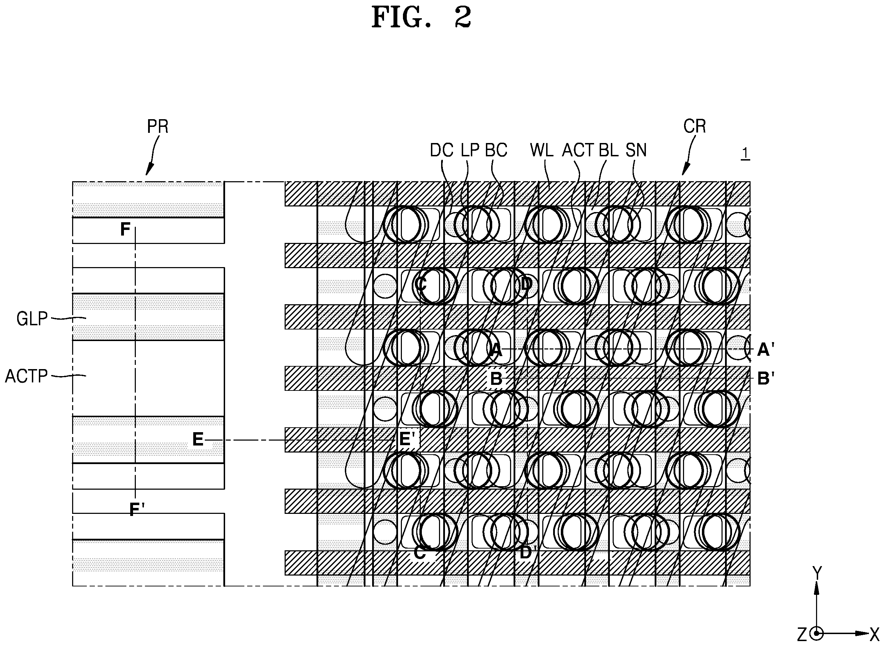

FIG. 2 is a schematic plan layout illustrating main elements of a semiconductor memory device 1 according to example embodiments.

Referring to FIG. 2, the semiconductor memory device 1 may include a memory cell region CR and the periphery region PR. The semiconductor memory device 1 may include a plurality of active regions ACT formed in the memory cell region CR and a plurality of logic active regions ACTP formed in the periphery region PR. The memory cell region CR may be the cell block SCB, where the plurality of memory cells are disposed, illustrated in FIG. 1.

In some embodiments, the plurality of active regions ACT disposed in the memory cell region CR may be disposed to have a long axis in a diagonal direction with respect to a first horizontal direction (e.g., an X direction) and a second horizontal direction (e.g., a Y direction). The first and second horizontal directions may be parallel with a main surface (e.g., an upper surface or a lower surface) of a substrate 110, which will be described later. The first and second horizontal directions may intersect each other. For example, the first and second horizontal directions may be orthogonal to each other.

A plurality of word lines WL may extend in parallel in the first horizontal direction (e.g., the X direction) across (overlapping in a third direction (e.g., a vertical direction or a Z direction)) the plurality of active regions ACT in the memory cell region CR. A plurality of bit lines BL may extend in parallel in the second horizontal direction (e.g., the Y direction) on (overlapping) the plurality of word lines WL. The plurality of bit lines BL may be connected (e.g., electrically connected) to the plurality of active regions ACT through a plurality of direct contacts DC. It will be understood that when an element or layer is referred to as being "coupled to", "connected to", "responsive to", or "on" another element or layer, it may be directly on, connected to, or coupled to the other element or layer, or one or more intervening elements or layers may be present. In contrast, when an element is referred to as being "directly coupled", "directly connected", "directly responsive to", or "directly on" another element, there are no intervening elements present. In addition, "electrical connection" conceptually includes a physical connection and a physical disconnection. As used herein, "an element A overlapping an element B in a direction X" (or similar language) means that there is at least one line that extends in the direction X and intersects both the elements A and B. An element A overlapping an element B may be only partially overlapping or may complete overlap the element in a particular direction.

In some embodiments, a plurality of buried contacts BC may be formed between two adjacent bit lines BL of the plurality of bit lines BL. In some embodiments, the plurality of buried contacts BC may be arranged in one row (or in one column) in each of the first horizontal direction (e.g., the X direction) and the second horizontal direction (e.g., the Y direction).

A plurality of landing pads LP may be formed on the plurality of buried contacts BC. Each of the plurality of landing pads LP may be disposed to overlap (e.g., overlap in the third direction) at least a portion of a corresponding buried contact BC of the plurality of buried contacts BC. In some embodiments, each of the plurality of landing pads LP may extend up to an upper portion of one of two adjacent bit lines BL.

A plurality of storage nodes SN may be formed on the plurality of landing pads LP. The plurality of storage nodes SN may be formed on the plurality of bit lines BL. The plurality of storage nodes SN may respectively be lower electrodes of a plurality of capacitors. The storage node SN may be connected (e.g., electrically connected) to the active region ACT through the landing pad LP and the buried contact BC.

A plurality of gate line patterns GLP may be disposed on the logic active region ACTP, in the periphery region PR. In FIG. 2, it is illustrated that the plurality of gate line patterns GLP extend in parallel in the first horizontal direction (e.g., the X direction) on the logic active region ACTP and have a certain width in the second horizontal direction (e.g., the Y direction), but the inventive concept is not limited thereto. For example, the plurality of gate line patterns GLP may have various widths or may vary in width and moreover, may have a flexure or may extend in various directions.

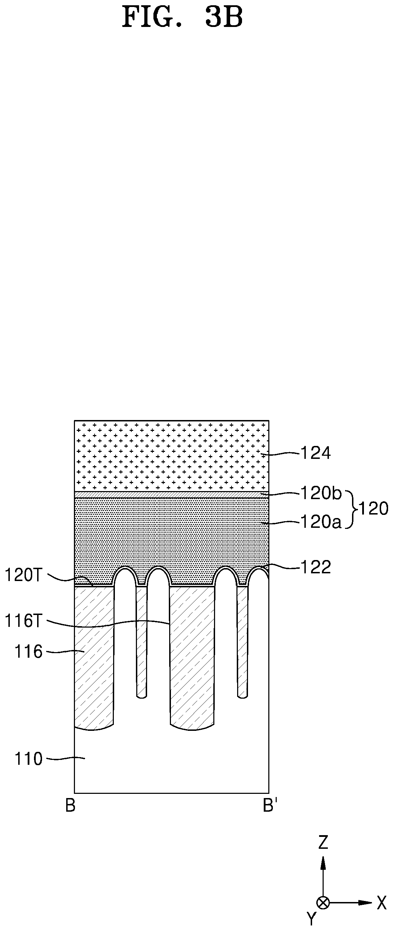

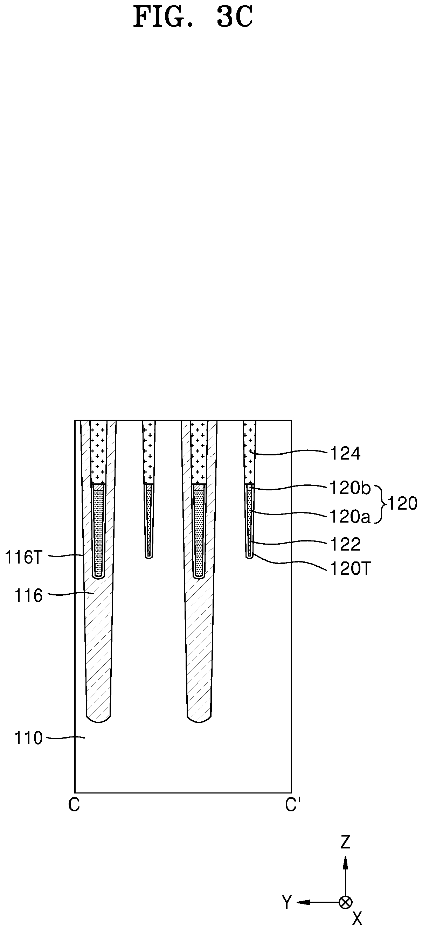

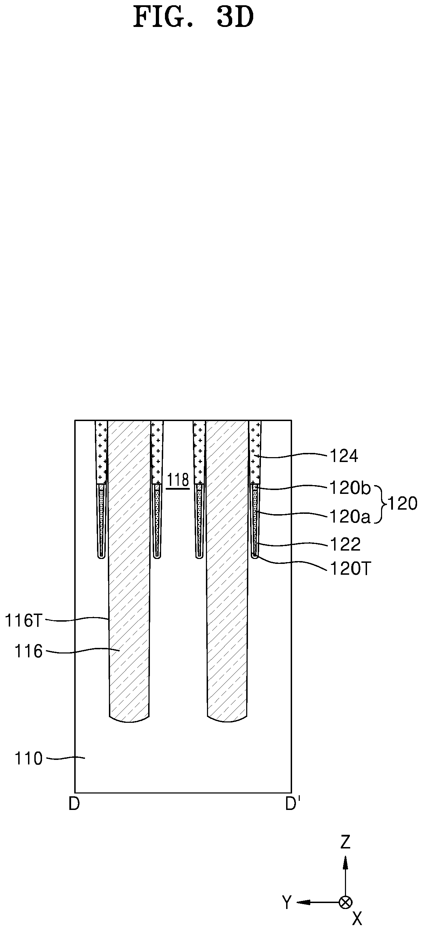

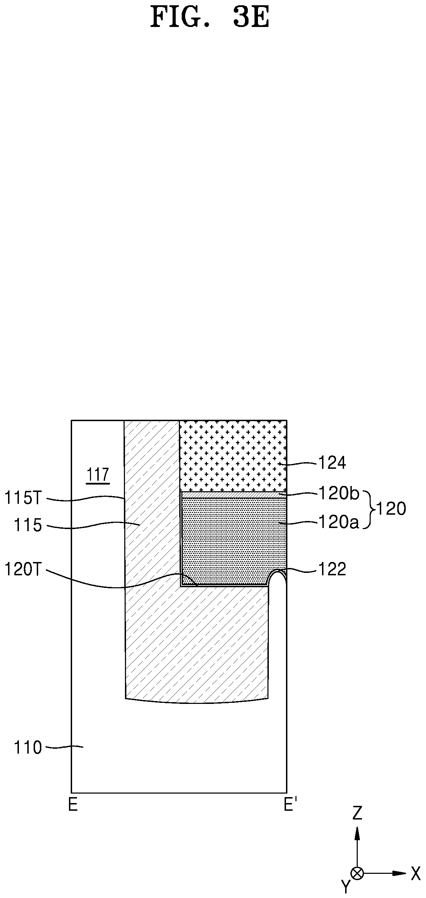

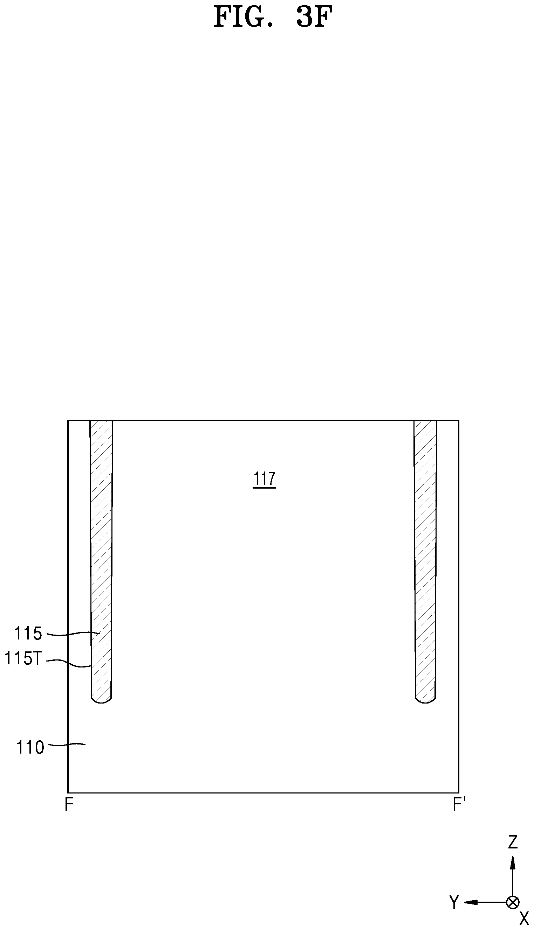

In FIG. 2, the other elements except the plurality of logic active regions ACTP and the plurality of gate line patterns GLP are omitted for convenience of the illustration, in the periphery region PR. Also, in FIG. 2, it is illustrated that the plurality of gate line patterns GLP are disposed on only the plurality of logic active regions ACTP, but the inventive concept is not limited thereto. For example, at least some of the plurality of gate line patterns GLP may extend to the outer side of the logic active region ACTP, namely, a logic device isolation layer (115 of FIGS. 3E and 3F). As used hereinafter, the terms "external/outside/outer side configuration", "external/outside/outer side device", "external/outside/outer side power", "external/outside/outer side signal", or "outside" are intended to broadly refer to a device, circuit, block, module, power, and/or signal that resides externally (e.g., outside of a functional or physical boundary) with respect to a given circuit, block, module, system, or device.

The plurality of gate line patterns GLP may be formed at the same level as the plurality of bit lines BL. Herein, a level, a vertical level, or height of an element may refer to a distance from a main surface (e.g., the upper surface or the lower surface) of the substrate 110 to the element in the third direction (e.g., the Z direction). The third direction may be orthogonal to the first and second horizontal directions. The third direction may be perpendicular to the upper surface (or the lower surface) of the substrate 110. For example, if element A is higher than element B, that may mean that element A is disposed farther than element B from the upper surface of the substrate 110 in the Z direction. In some embodiments, the plurality of gate line patterns GLP and the plurality of bit lines BL may include the same material, or at least partial portions thereof may include the same material. For example, a process of forming all or some of the plurality of gate line patterns GLP may be the same as a process of forming all or some of the plurality of bit lines BL. In some embodiments, the plurality of gate line patterns GLP and the plurality of bit lines BL may be formed by a same process or a series of processes simultaneously.

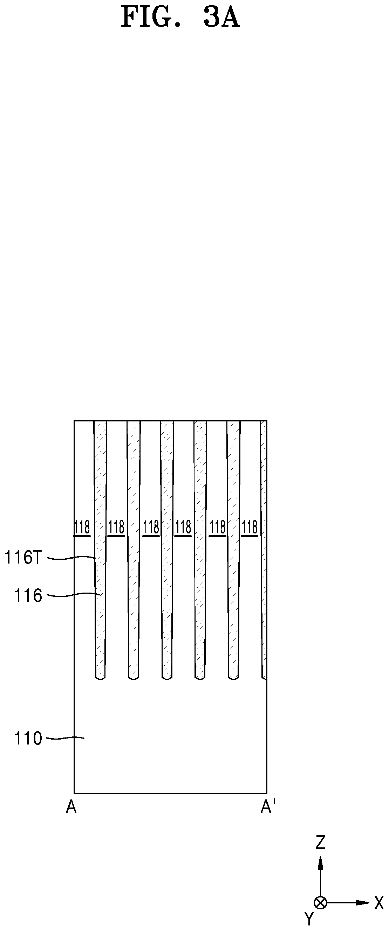

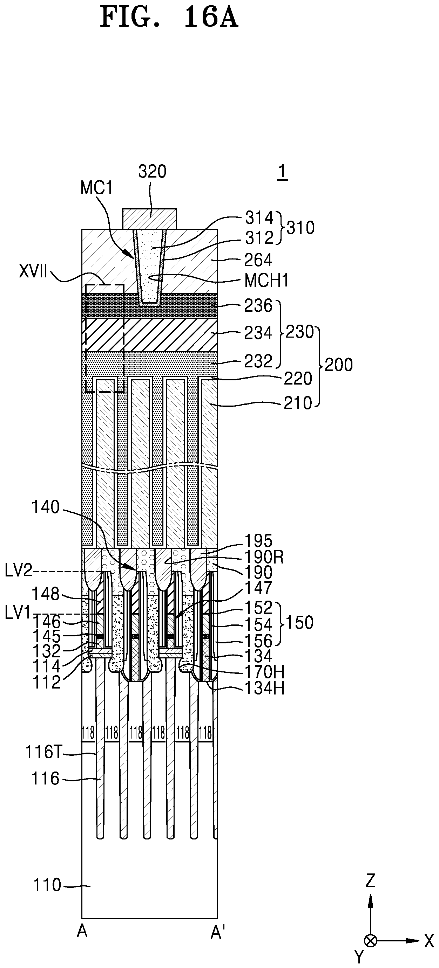

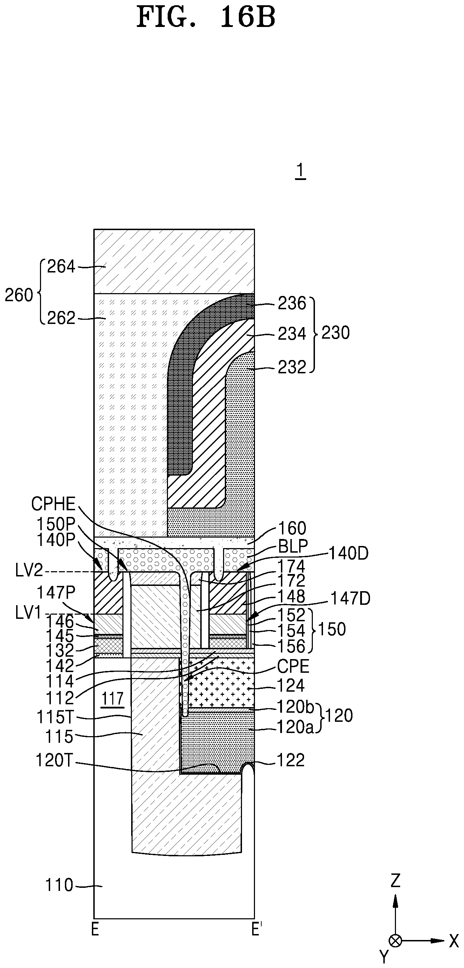

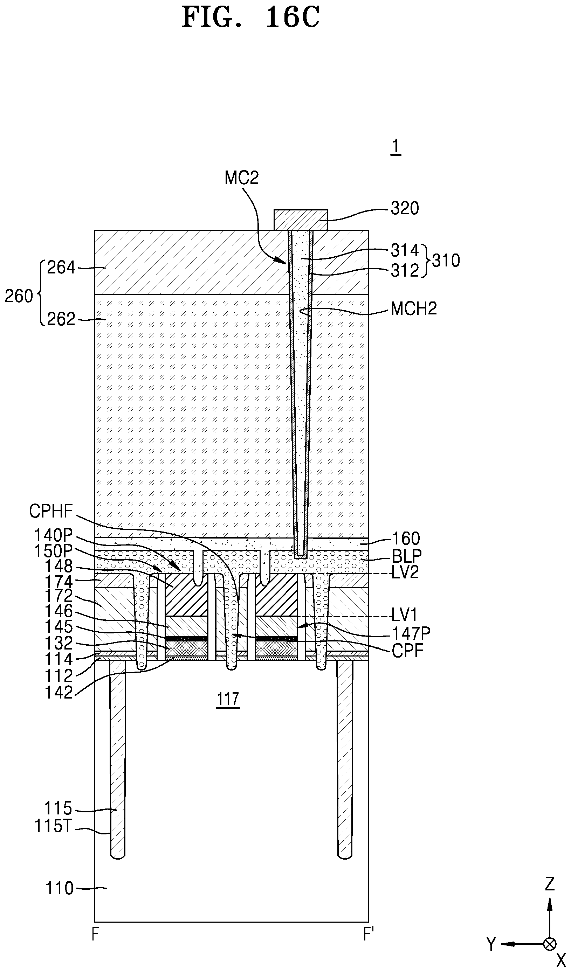

FIGS. 3A to 3F, 4A to 4F, 5A to 5F, 6A to 6F, 7A to 7F, 8A to 8F, 9A to 9F, 10A to 10F, 11A to 11C, 12A to 12C, 13A to 13C, 14A to 14C, and 15A to 15C are cross-sectional views illustrating a method of manufacturing a semiconductor memory device, according to example embodiments, and FIGS. 16A to 16C are cross-sectional views illustrating a semiconductor memory device according to example embodiments. In detail, FIGS. 3A, 4A, 5A, 6A, 7A, 8A, 9A, 10A, 11A, 12A, 13A, 14A, 15A, and 16A are cross-sectional views taken along positions corresponding to line A-A' of FIG. 2, FIGS. 3B, 4B, 5B, 6B, 7B, 8B, 9B, and 10B are cross-sectional views taken along positions corresponding to line B-B' of FIG. 2, FIGS. 3C, 4C, 5C, 6C, 7C, 8C, 9C, and 10C are cross-sectional views taken along positions corresponding to line C-C' of FIG. 2, FIGS. 3D, 4D, 5D, 6D, 7D, 8D, 9D, and 10D are cross-sectional views taken along positions corresponding to line D-D' of FIG. 2, FIGS. 3E, 4E, 5E, 6E, 7E, 8E, 9E, 10E, 11B, 12B, 13B, 14B, 15B, and 16B are cross-sectional views taken along positions corresponding to line E-E' ofFIG. 2, and FIGS. 3F, 4F, 5F, 6F, 7F, 8F, 9F, 10F, 11C, 12C, 13C, 14C, 15C, and 16C are cross-sectional views taken along positions corresponding to line F-F' of FIG. 2.

Referring to FIGS. 3A to 3F, a device isolation trench 116T and a logic device isolation trench 115T may be formed in a substrate 110, and a device isolation layer 116, which (at least partially) fills the device isolation trench 116T, and a logic device isolation layer 115, which (at least partially) fills the logic device isolation trench 115T, may be formed on (in) the substrate 110.

In some embodiments, the substrate 110 may include, for example, silicon (Si), such as crystalline Si, poly-crystalline Si, and/or amorphous Si. In some embodiments, the substrate 110 may include a semiconductor element, such as germanium (Ge), or a compound semiconductor, such as silicon germanium (SiGe), silicon carbide (SiC), gallium arsenide (GaAs), indium arsenide (InAs), and indium phosphide (InP). In some embodiments, the substrate 110 may have a silicon on insulator (SOI) structure. For example, the substrate 110 may include a buried oxide (BOX) layer. The substrate 110 may include a conductive region, for example, an impurity-doped well and/or an impurity-doped structure. As used herein, the term "and/or" includes any and all combinations of one or more of the associated listed items. Expressions such as "at least one of," when preceding a list of elements, modify the entire list of elements and do not modify the individual elements of the list.

The device isolation layer 116 and the logic device isolation layer 115 may include, for example, an insulation material, such as silicon oxide, silicon nitride, and/or silicon oxynitride. The device isolation layer 116 may include a single layer including one kind of insulation layer, a double layer including two kinds of insulation layers, or a multilayer including a combination of at least three kinds of insulation layers. For example, the device isolation layer 116 may include a double layer or a multilayer including oxide and nitride. However, according to an embodiment, a configuration of the device isolation layer 116 is not limited to the above description. A plurality of active regions 118 may be defined in the substrate 110 in a memory cell region (the memory cell region CR of FIG. 2), based on the device isolation layer 116, and a plurality of logic active regions 117 may be defined in the substrate 110 in a periphery region (the periphery region PR of FIG. 2), based on the logic device isolation layer 115.

The device isolation layer 116 may be a portion, defining a plurality of active regions 118, of the device isolation structure, and the logic device isolation layer 115 may be a portion, defining a plurality of logic active regions 117, of the device isolation structure. In some embodiments, the device isolation layer 116 and the logic device isolation layer 115 may be formed together and may be referred to as a device isolation structure. The device isolation layer 116 and the logic device isolation layer 115 may not be clearly differentiated from each other in a boundary portion between the memory cell region CR and the periphery region PR.

The active region 118 may one-dimensionally have a relatively long island shape (in a plan view) which has a short axis and a long axis as in the active region ACT illustrated in FIG. 2. The logic active region 117 may one-dimensionally have a rectangular shape as in the logic active region ACTP illustrated in FIG. 2 but is not limited thereto and may have other planar shapes. The active region 118 may configure (e.g., may be) the active region ACT in FIG. 2, and the logic active region 117 may configure (e.g., may be) the logic active region ACTP in FIG. 2.

A plurality of word line trenches 120T may be formed in the substrate 110. The plurality of word line trenches 120T may extend in parallel in the first horizontal direction (e.g., the X direction) and may have a line shape where the word line trenches 120T are arranged at equal intervals in the second horizontal direction (e.g., the Y direction) across (overlapping in the third direction) the active region 118. In some embodiments, a step height (e.g., a mound shape in a cross-sectional view) may be formed in a lower surface of each of the plurality of word line trenches 120T.

A resultant material where the plurality of word line trenches 120T are formed may be cleaned, and then, a plurality of gate dielectric layers 122, a plurality of word lines 120, and a plurality of buried insulation layers 124 may be sequentially formed in the plurality of word line trenches 120T. The plurality of word lines 120 may configure (e.g., may be) the plurality of word lines WL illustrated in FIG. 2. The plurality of word lines 120 may extend in parallel in the first horizontal direction (e.g., the X direction) and may have a line shape where the word line trenches 120T are arranged at equal intervals in the second horizontal direction (e.g., the Y direction) across (overlapping in the third direction) the active region 118. An upper surface of each of the plurality of word lines 120 may be disposed at a level which is lower than an upper surface of the substrate 110. For example, the upper surface of each of the plurality of word lines 120 may be closer than the upper surface of the substrate 110 to the lower surface of the substrate 110 in the third direction). A lower surface of each of the plurality of word lines 120 may have a concave-convex shape, and a saddle fin field effect transistor (FinFET) may be formed in the plurality of active regions 118. For example, the lower surface of each of the plurality of word lines 120 may include a portion convex toward the lower surface of the substrate 110.

Each of the plurality of word lines 120 may have a stack structure of a lower word line layer 120a and an upper word line layer 120b. For example, the lower word line layer 120a may include, for example, a metal material, conductive metal nitride, or a combination thereof. In some embodiments, the lower word line layer 120a may include titanium (Ti), titanium nitride (TiN), tantalum (Ta), tantalum nitride (TaN), tungsten (W), tungsten nitride (WN), titanium silicon nitride (TiSiN), tungsten silicon nitride (WSiN), and/or a combination thereof. For example, the upper word line layer 120b may include doped polysilicon. In some embodiments, the lower word line layer 120a may include a core layer and a barrier layer disposed between the core layer and the gate dielectric layer 122.

In some embodiments, before or after the plurality of word lines 120 are formed, a source region and a drain region may be formed in the plurality of active regions 118 by implanting impurity ions into a portion of the active region 118 of the substrate 110 at both (e.g., opposite) sides of the plurality of word lines 120.

The gate dielectric layer 122 may include, for example, a silicon oxide film, a silicon nitride film, a silicon oxynitride film, oxide/nitride/oxide (ONO), and a high-k dielectric film having a dielectric constant that is higher than that of the silicon oxide film. For example, the gate dielectric layer 122 may have a dielectric constant of (about) 10 to (about) 25.

An upper surface of each of the plurality of buried insulation layer 124 may be disposed at substantially the same level as the upper surface of the substrate 110. The buried insulation layer 124 may include, for example, a silicon oxide film, a silicon nitride film, a silicon oxynitride film, and/or a combination thereof.

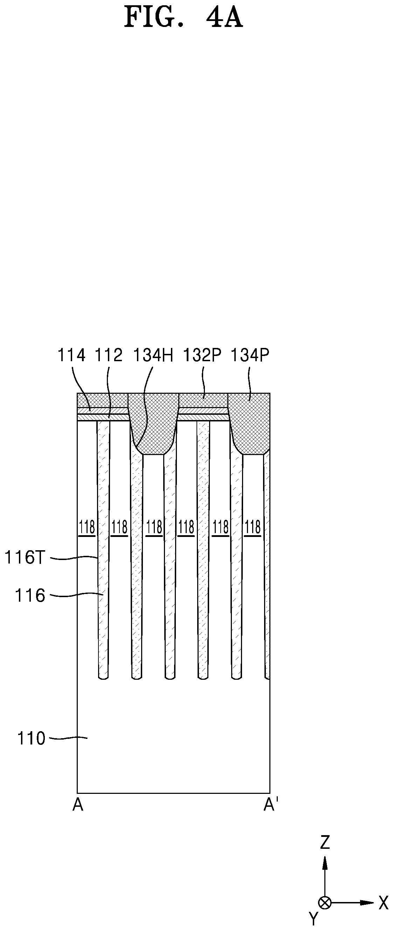

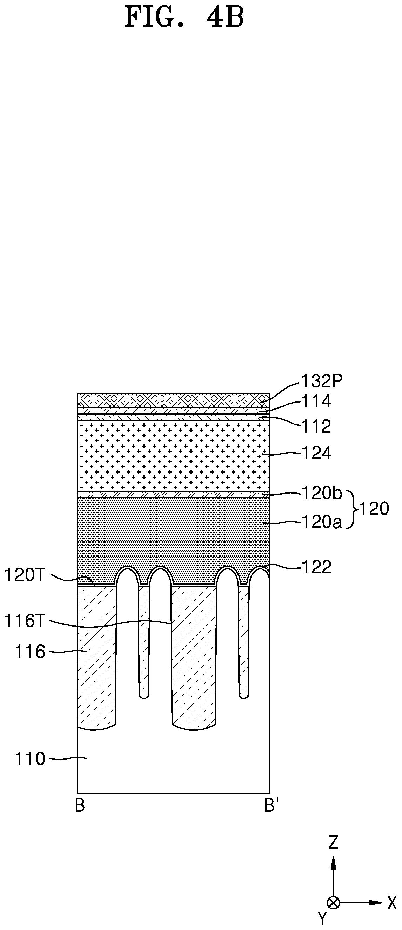

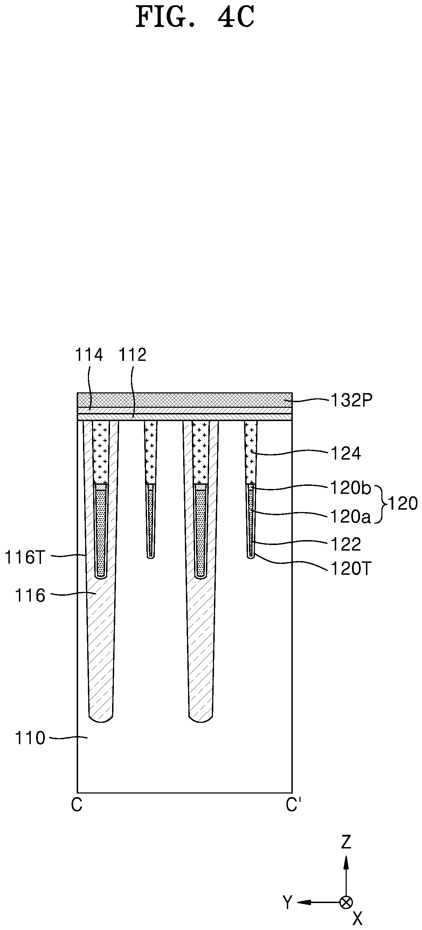

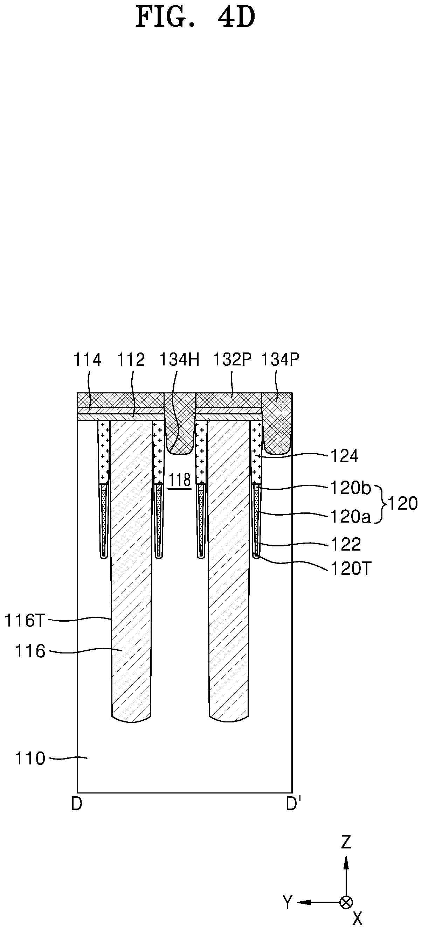

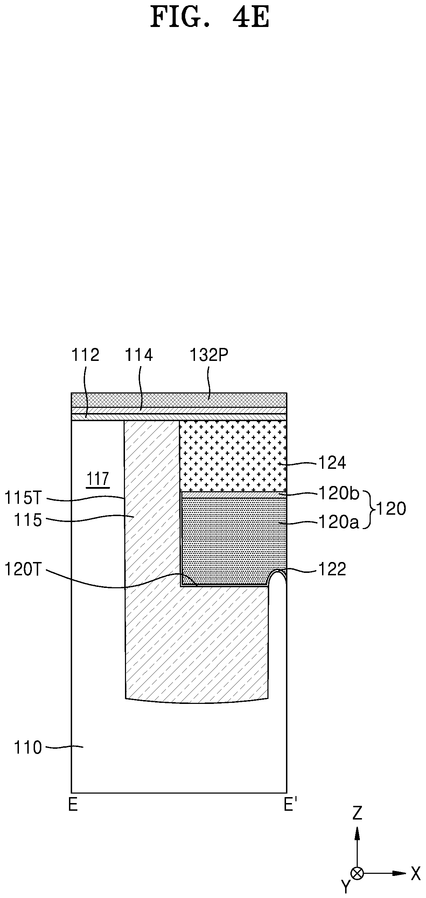

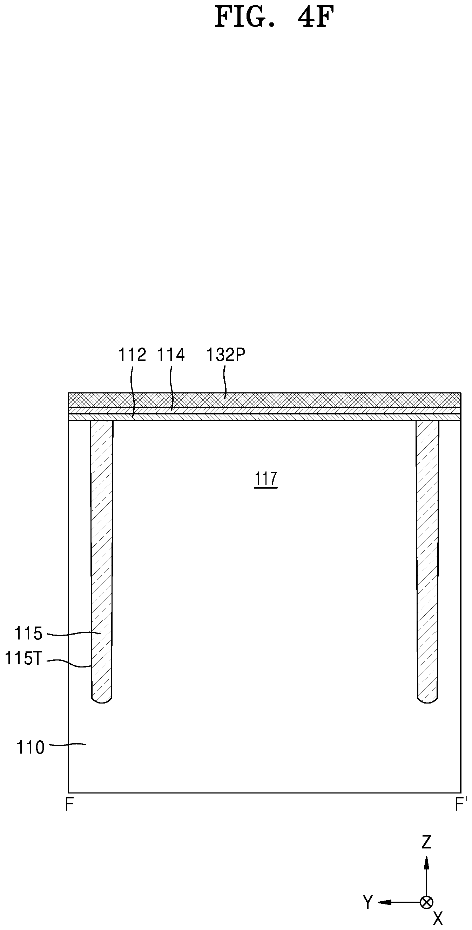

Referring to FIGS. 4A to 4F, a first insulation layer pattern 112 and a second insulation layer pattern 114, which are sequentially disposed on (e.g., cover or overlap in the third direction) the device isolation layer 116, the plurality of active regions 118, the plurality of buried insulation layers 124, the logic device isolation layer 115, and the plurality of logic active regions 117, may be formed. For example, a stack structure of the first insulation layer pattern 112 and the second insulation layer pattern 114 may include a silicon oxide film, a silicon nitride film, a silicon oxynitride film, a metal-group dielectric film, and/or a combination thereof. The stack structure of the first insulation layer pattern 112 and the second insulation layer pattern 114 may be referred to as an insulation layer pattern. In some embodiments, the insulation layer pattern may be formed by stacking a plurality of insulation layers including the stack structure of the first insulation layer pattern 112 and the second insulation layer pattern 114. In some embodiments, the first insulation layer pattern 112 may include, for example, silicon oxide and the second insulation layer pattern 114 may include, for example, silicon oxynitride. In some embodiments, the first insulation layer pattern 112 may include, for example, a nonmetal-group dielectric film such as a silicon oxide film, a silicon nitride film, or a silicon oxynitride film, and the second insulation layer pattern 114 may include, for example, a metal-group dielectric film. In some embodiments, the second insulation layer pattern 114 may be thicker than the first insulation layer pattern 112 (in the third direction). For example, the first insulation layer pattern 112 may have a thickness of (about) 50 Å to (about) 90 Å (in the third direction), and the second insulation layer pattern 114 may be thicker than the first insulation layer pattern 112 and may have a thickness of (about) 60 Å to (about) 100 Å (in the third direction).

A conductive semiconductor layer 132P may be formed on the first insulation layer pattern 112 and the second insulation layer pattern 114, and then, a direct contact hole 134H, which extends in (e.g., passes through) a stack structure of the conductive semiconductor layer 132P, the first insulation layer pattern 112, and the second insulation layer pattern 114 to expose the source region of the active region 118, may be formed and a direct contact conductive layer 134P (at least partially) filling the direct contact hole 134H may be formed. In some embodiments, the direct contact hole 134H may extend to the inner portion of the active region 118, namely, the source region. The conductive semiconductor layer 132P may include, for example, doped polysilicon. The direct contact conductive layer 134P may include, for example, doped polysilicon. In some embodiments, the direct contact conductive layer 134P may include, for example, an epitaxial silicon layer.

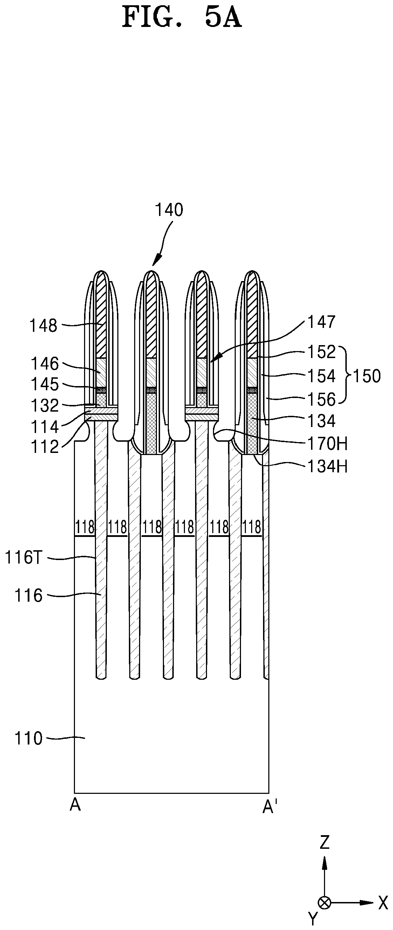

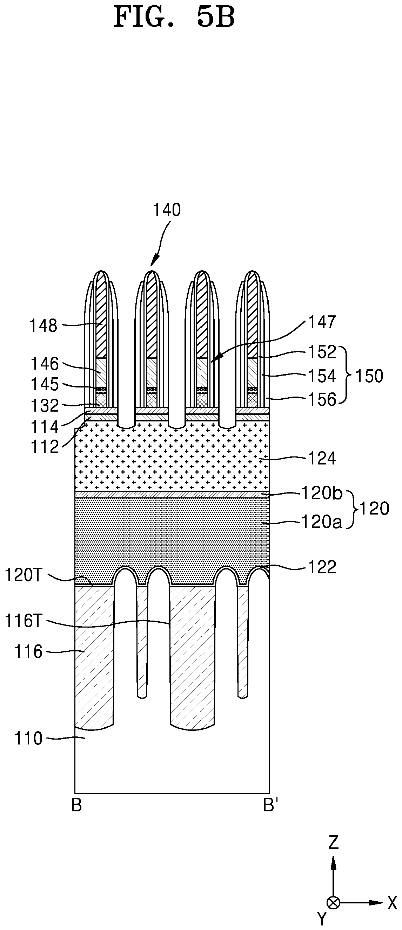

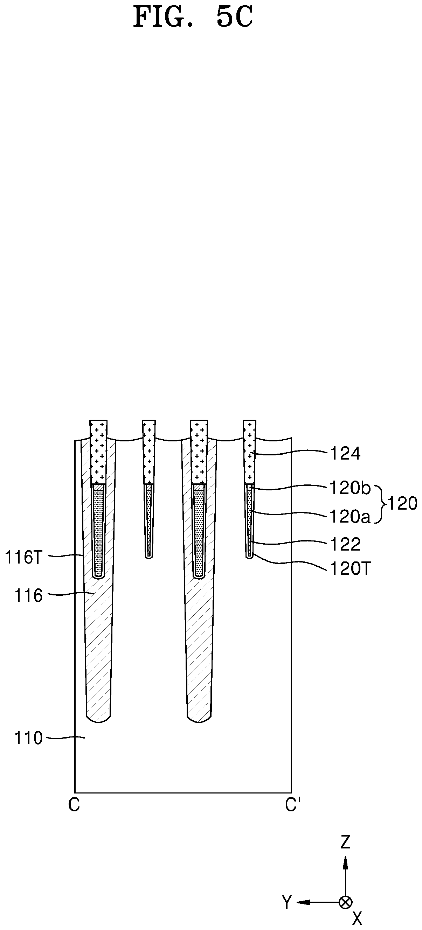

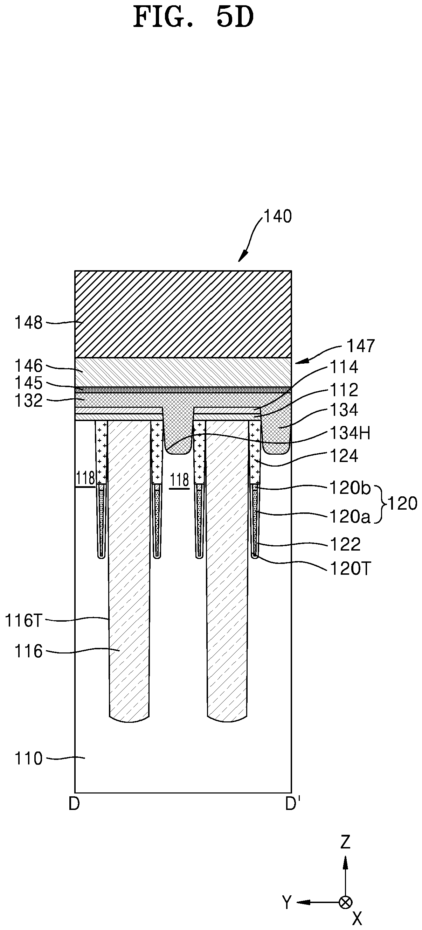

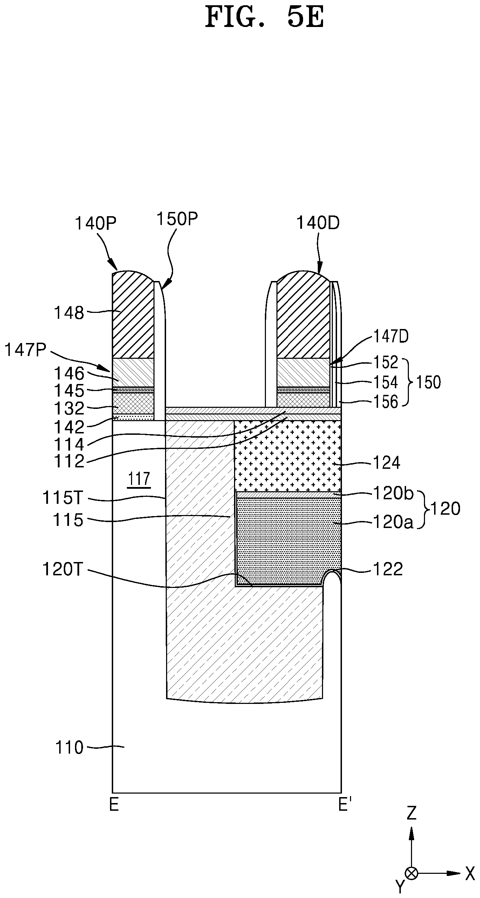

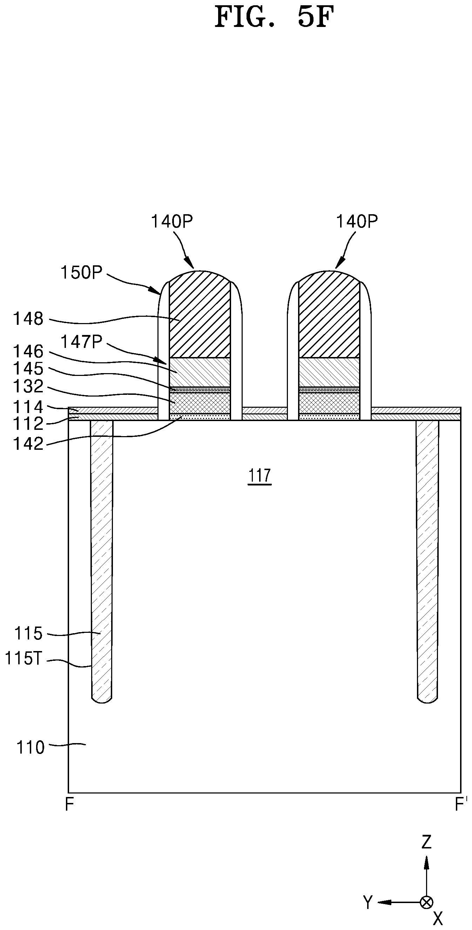

Referring to FIGS. 4A to 4F and 5A to 5F, a metal-group conductive layer and an insulation capping layer may be sequentially formed on (e.g., to cover or overlap in the third direction) the conductive semiconductor layer 132P and the direct contact conductive layer 134P and form the bit line structure 140. In some embodiments, the metal-group conductive layer may be a stack structure of a first metal-group conductive layer and a second metal-group conductive layer. A plurality of bit lines 147 each including a stack structure of a first metal-group conductive pattern 145 and a second metal-group conductive pattern 146 each having a line shape and a plurality of insulation capping lines 148 on (e.g., covering or overlapping in the third direction) the plurality of bit lines 147 may be formed by etching the first metal-group conductive layer, the second metal-group conductive layer, and the insulation capping layer.

In some embodiments, the first metal-group conductive pattern 145 may include, for example, titanium nitride (TiN) and/or Ti-Si-N (TSN), and the second metal-group conductive pattern 146 may include, for example, W and/or tungsten silicide (WSix). In some embodiments, the first metal-group conductive pattern 145 may perform a function of a diffusion barrier. In some embodiments, the plurality of insulation capping lines 148 may include, for example, silicon nitride.

One bit line 147 and one insulation capping line 148 on (e.g., covering or overlapping in the third direction) the one bit line 147 may configure one bit line structure 140. A plurality of bit line structures 140 each including the bit line 147 and the insulation capping line 148 on (e.g., covering or overlapping in the third direction) the bit line 147 may extend in the second horizontal direction (the Y direction). The plurality of bit lines 147 may configure (e.g., may be) the plurality of bit lines BL illustrated in FIG. 2. In some embodiments, the bit line structure 140 may further include a conductive semiconductor pattern 132, which is a portion of the conductive semiconductor layer 132P disposed between the second insulation layer pattern 114 and the first metal-group conductive pattern 145.

In an etching process of forming the plurality of bit lines 147, a plurality of conductive semiconductor patterns 132 and a plurality of direct contact conductive patterns 134 may be formed by removing, through an etching process, a portion of the conductive semiconductor layer 132P and a portion of the direct contact conductive layer 134P, which do not vertically overlap (e.g., do not overlap in the third direction) the bit line 147. In this case, a stack structure of the first insulation layer pattern 112 and the second insulation layer pattern 114 may perform a function of an etch stop layer in an etching process of forming the plurality of bit lines 147, the plurality of conductive semiconductor patterns 132, and the plurality of direct contact conductive patterns 134. The plurality of direct contact conductive patterns 134 may configure (e.g., may be) the plurality of direct contacts DC illustrated in FIG. 2. The plurality of bit lines 147 may be electrically connected to the plurality of active regions 118 through the plurality of direct contact conductive patterns 134.

Both sidewalls (e.g., opposite sidewalls in the first horizontal direction) of each of the plurality of bit line structures 140 may be covered by an insulation spacer structure 150. For example, the insulation spacer structure 150 may be on the opposite sidewalls in the first horizontal direction of each of the plurality of bit line structures 140. Each of a plurality of insulation spacer structures 150 may include a first insulation spacer 152, a second insulation spacer 154, and a third insulation spacer 156. The second insulation spacer 154 may include a material having a dielectric constant that is lower than that of a material in the first insulation spacer 152 and/or the third insulation spacer 156. In some embodiments, the first insulation spacer 152 and the third insulation spacer 156 may include, for example nitride, and the second insulation spacer 154 may include, for example, oxide. In some embodiments, the first insulation spacer 152 and the third insulation spacer 156 may include, for example, nitride, and the second insulation spacer 154 may include, for example, a material having an etch selectivity with respect to the first insulation spacer 152 and the third insulation spacer 156. For example, when the first insulation spacer 152 and the third insulation spacer 156 include nitride, the second insulation spacer 154 may include oxide, and in this case, an air spacer may be formed by removing the second insulation spacer 154 in a subsequent process.

Each of a plurality of buried contact holes 170H may be formed between two adjacent bit lines 147 of the plurality of bit lines 147. An internal space of each of the plurality of buried contact holes 170H may be defined by the active region 118 and the insulation spacer structure 150 on (e.g., covering or overlapping in the first horizontal direction) a sidewall of each of two adjacent bit lines 147, between two adjacent bit lines 147 of the plurality of bit lines 147. For example, each of the buried contact holes 170H may expose at least a portion of the active region 118 and a portion of the insulation spacer structure 150 between two adjacent bit lines 147 of the plurality of bit lines 147.

The plurality of buried contact holes 170H may be formed by removing a portion of each of the active region 118 and the stack structure of the first insulation layer pattern 112 and the second insulation layer pattern 114 by using, as an etch mask, the insulation spacer structure 150 on (e.g., covering or overlapping in the first horizontal direction) both sidewalls (e.g., opposite sidewalls in the first horizontal direction) of each of the plurality of bit line structures 140. In some embodiments, an anisotropic etching process of removing a portion of each of the active region 118 and the stack structure of the first insulation layer pattern 112 and the second insulation layer pattern 114 by using, as an etch mask, the insulation spacer structure 150 on (e.g., covering or overlapping in the first horizontal direction) both sidewalls (e.g., opposite sidewalls in the first horizontal direction) of each of the plurality of bit line structures 140 may be first performed, and then, an isotropic etching process of further removing another portion of the active region 118, thereby forming the plurality of buried contact holes 170H so that a space defined by the active region 118 extends.

A plurality of gate line structures 140P may be formed in the logic active region 117. In some embodiments, at least one dummy bit line structure 140D may be disposed between the bit line structure 140 and the gate line structure 140P.

The gate line structure 140P may include a gate line 147P and an insulation capping line 148 on (e.g., covering or overlapping in the third direction) the gate line 147P. A plurality of gate lines 147P included in the plurality of gate line structures 140P may be formed together with the plurality of bit lines 147. That is, the gate line 147P may have a stack structure of the first metal-group conductive pattern 145 and the second metal-group conductive pattern 146. A gate insulation layer pattern 142 may be disposed between the gate line 147P and the logic active region 117. In some embodiments, the gate line structure 140P may further include a conductive semiconductor pattern 132 disposed between the gate insulation layer pattern 142 and the first metal-group conductive pattern 145. The plurality of gate lines 147P may configure (e.g., may be) the plurality of gate line patterns GLP illustrated in FIG. 2.

A sidewall of the gate line structure 140P may be covered by the gate insulation spacer 150P. The gate insulation spacer 150P may be on a sidewall of the gate line structure 140P. The gate insulation spacer 150P may include, for example, nitride. In some embodiments, the gate insulation spacer 150P may include a single layer but is not limited thereto and may include a plurality of stack structures of two or more layers. For example, similar to the insulation spacer structure 150, the gate insulation spacer 150P may include a stack structure of at least three layers.

The dummy bit line structure 140D may extend in parallel in the second horizontal direction (the Y direction) with the bit line structure 140. The dummy bit line structure 140D may have a structure that is similar to the bit line structure 140. The dummy bit line structure 140D may include a dummy bit line 147D, including the first metal-group conductive pattern 145 and the second metal-group conductive pattern 146, and an insulation capping line 148 on (e.g., covering or overlapping in the third direction) the dummy bit line 147D. A sidewall of the dummy bit line structure 140D may be covered by at least one of the insulation spacer structure 150 and the gate insulation spacer 150P.

In some embodiments, a width of the dummy bit line 147D in the first horizontal direction (e.g., the X direction) may have a value that is greater than that of a width of the bit line 147 (in the first horizontal direction). In some embodiments, the width of the dummy bit line 147D in the first horizontal direction (the X direction) may have the same value as that of the width of the bit line 147 (in the first horizontal direction). In some embodiments, the dummy bit line structure 140D may be provided in plurality, a width of the dummy bit line 147D of some of the plurality of dummy bit line structures 140D in the first horizontal direction (e.g., the X direction) may have a value that is greater than that of a width of the bit line 147 (in the first horizontal direction), and a width of the dummy bit line 147D of the others of the plurality of dummy bit line structures 140D in the first horizontal direction (e.g., the X direction) may have the same value as that of the width of the bit line 147 (in the first horizontal direction).

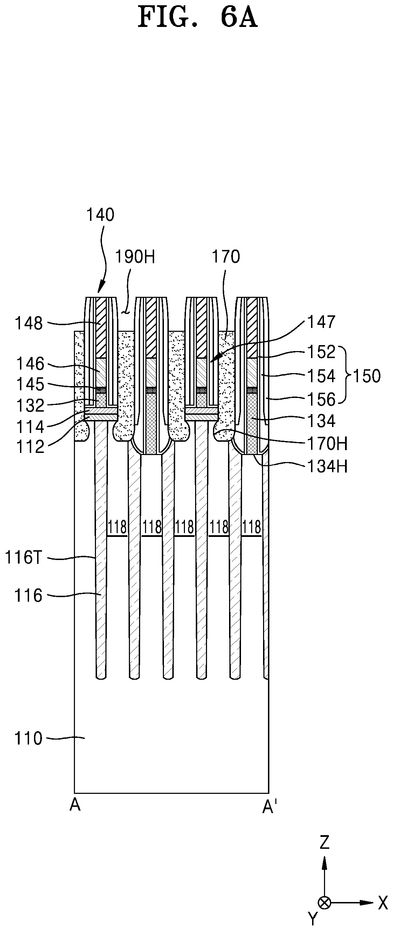

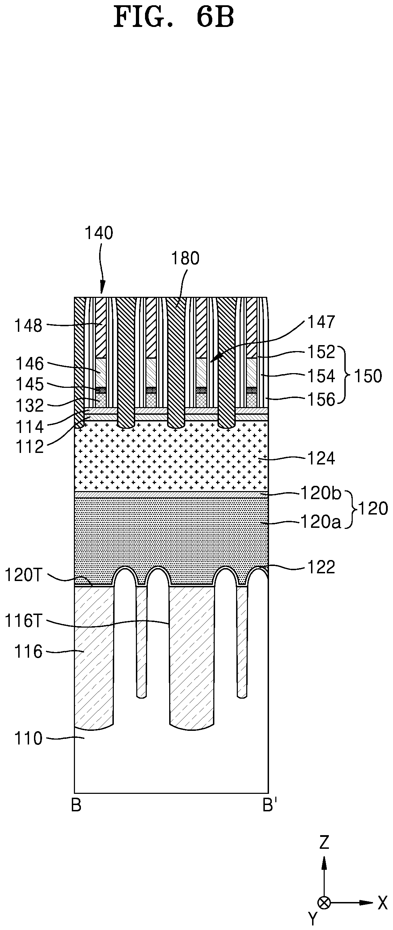

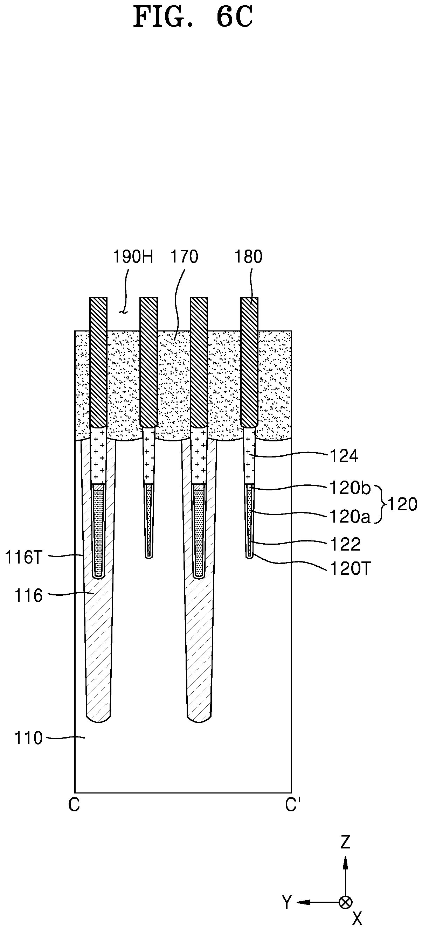

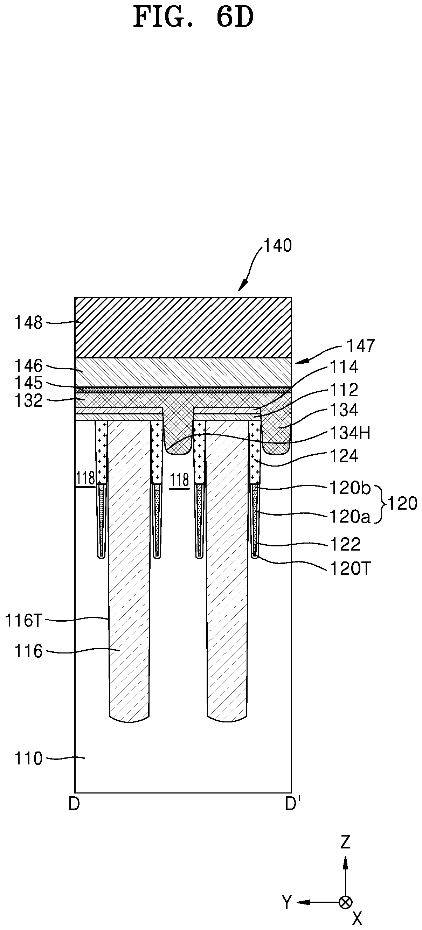

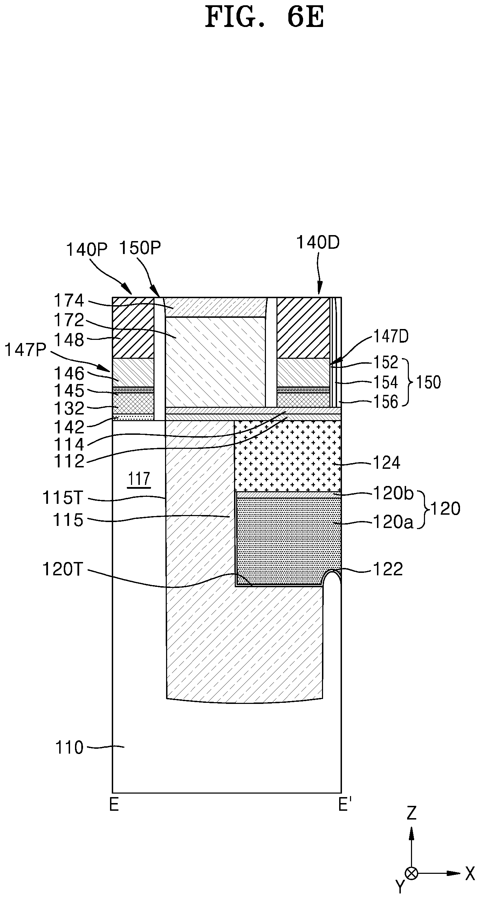

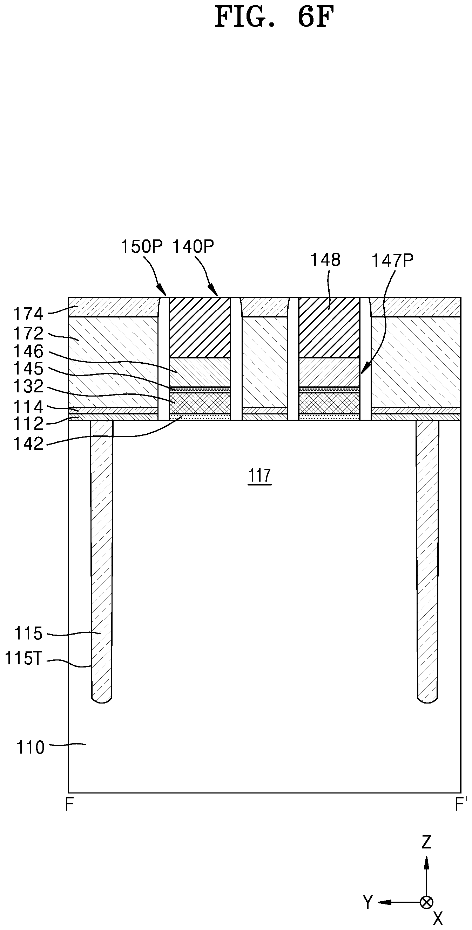

Referring to FIGS. 6A to 6F, a plurality of buried contacts 170 and a plurality of insulation fences 180 may be formed in a space between (a pair of insulation spacer structures 150, facing each other, of) the plurality of insulation spacer structures 150 on (e.g., covering or overlapping in the first horizontal direction) every two adjacent sidewalls (e.g., opposite sidewalls in the first horizontal direction) of the plurality of bit line structures 140. The plurality of buried contacts 170 and the plurality of insulation fences 180 may be alternately arranged in the second horizontal direction (e.g., the Y direction). For example, the plurality of buried contacts 170 may include polysilicon. For example, the plurality of insulation fences 180 may include nitride.

In some embodiments, the plurality of buried contacts 170 may be arranged in one row in each of the first horizontal direction (e.g., the X direction) and the second horizontal direction (e.g., the Y direction). Each of the plurality of buried contacts 170 may extend from the active region 118 in the third direction (e.g., the vertical direction or the Z direction). The plurality of buried contacts 170 may configure (e.g., may be) the plurality of buried contacts BC illustrated in FIG. 2.

The plurality of buried contacts 170 may be disposed in a space defined by (e.g., a space between adjacent insulation spacer structures 150 among the plurality of insulation spacer structures 150) the plurality of insulation spacer structures 150 on (e.g., covering or overlapping in the first horizontal direction) the every two adjacent sidewalls (e.g., the opposite sidewalls in the first horizontal direction) of the plurality of bit line structures 140 and the plurality of insulation fences 180. The plurality of buried contacts 170 may (at least) fill a portion of a lower side of a space between the plurality of insulation spacer structures 150 on (e.g., covering or overlapping in the first horizontal direction) the every two adjacent sidewalls (e.g., the opposite sidewalls in the first horizontal direction) of the plurality of bit line structures 140.

A level of an upper surface of each of the plurality of buried contacts 170 may be disposed lower than a level of an upper surface of each of the plurality of insulation capping lines 148. An upper surface of each of the plurality of insulation fences 180 and the upper surface of each of the plurality of insulation capping lines 148 may be disposed at the same level in the third (or vertical) direction (e.g., the Z direction).

A plurality of landing pad holes 190H may be defined by the plurality of insulation spacer structures 150 and the plurality of insulation fences 180. The plurality of buried contacts 170 may be exposed at (by) lower surfaces of the plurality of landing pad holes 190H. For example, the landing pad hole 190H may be formed to expose an upper surface of the buried contact 170, a sidewall of the insulation fence 180, and a sidewall of the insulation spacer structure 150.

A stack structure of a first interlayer insulation layer 172 and a second interlayer insulation layer 174 may be formed on a stack structure of the first insulation layer pattern 112 and the second insulation layer pattern 114 on the peripheries of (or adjacent) the plurality of gate line structures 140P. In some embodiments, the first interlayer insulation layer 172 may include, for example, oxide, and the second interlayer insulation layer 174 may include, for example, nitride. An upper surface of the second interlayer insulation layer 174 and an upper surface of the gate line structure 140P may have the same level. The stack structure of the first interlayer insulation layer 172 and the second interlayer insulation layer 174 may be referred to as an interlayer insulation layer.

In a process of forming the plurality of buried contacts 170 and the plurality of insulation fences 180, a portion of an upper side of each of the insulation capping line 148 included in the bit line structure 140, the dummy bit line structure 140D, and the gate line structure 140P, the gate insulation spacer 150P, and the insulation spacer structure 150 may be removed, and thus, a level of an upper surface of each of the bit line structure 140, the dummy bit line structure 140D, and the gate line structure 140P may be lowered.

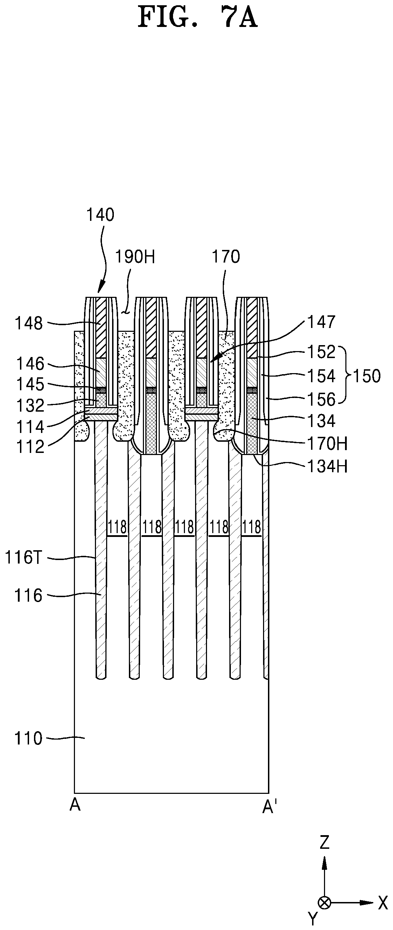

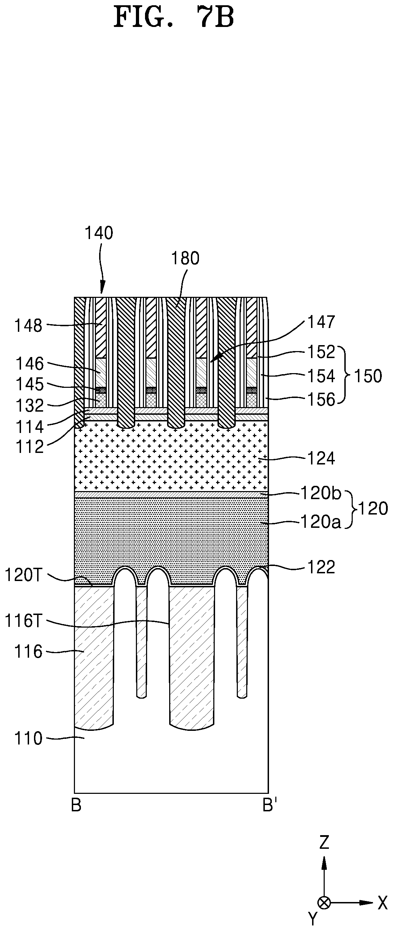

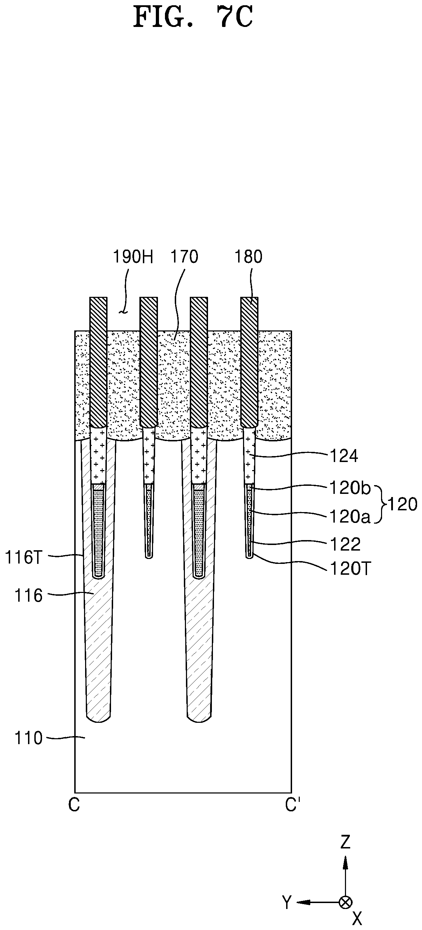

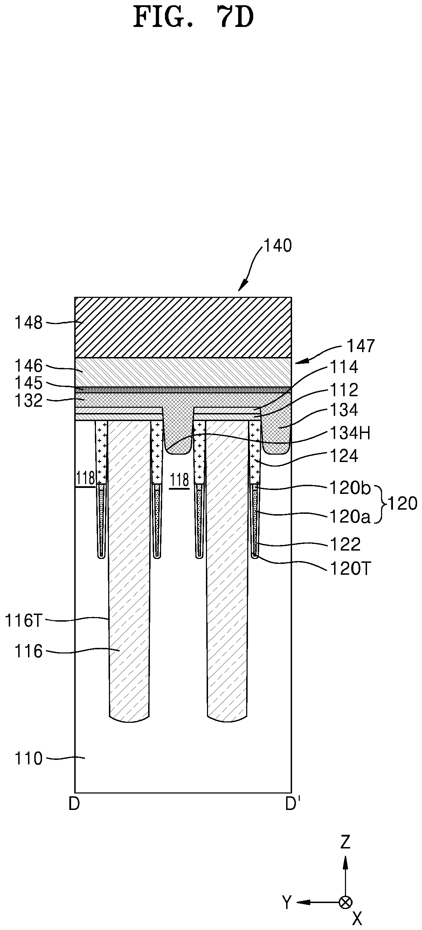

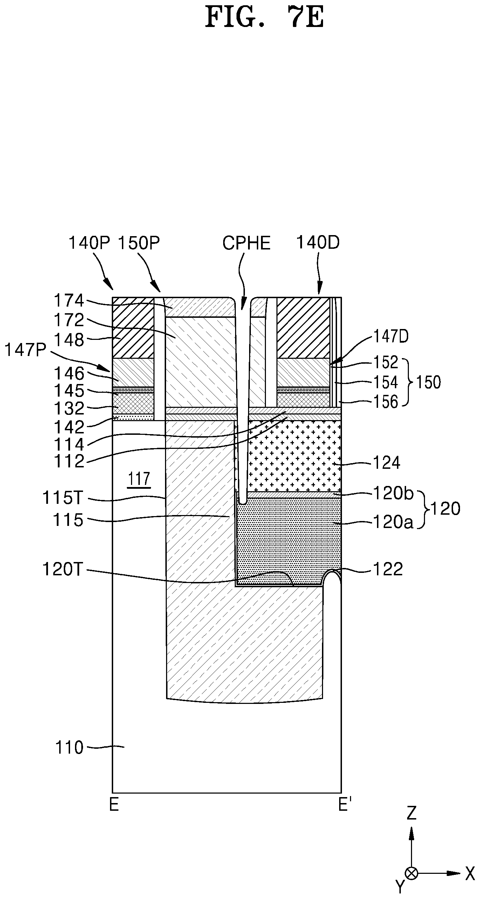

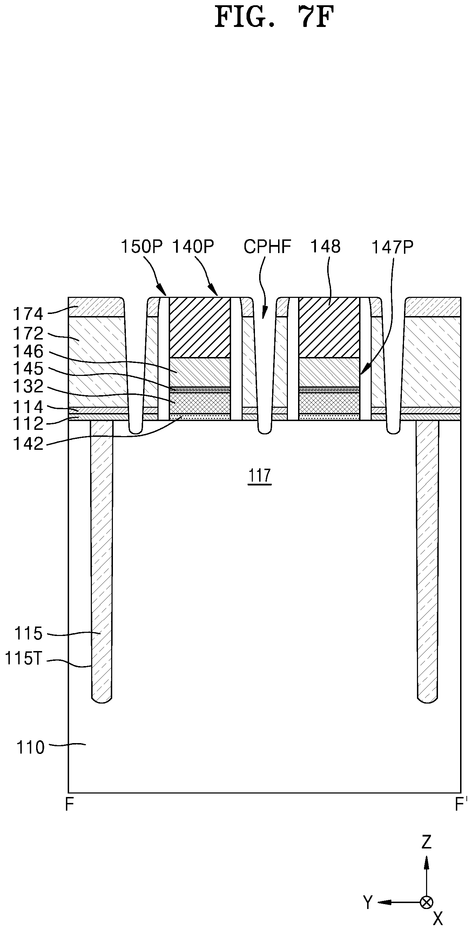

Referring to FIGS. 7A to 7F, a word line contact hole CPHE and a logic active region contact hole CPHF each extending in (e.g., passing through) the second interlayer insulation layer 174, the first interlayer insulation layer 172, the second insulation layer pattern 114, and the first insulation layer pattern 112 may be formed. The word line contact hole CPHE and the logic active region contact hole CPHF may be referred to as a plurality of contact holes. The word line contact hole CPHE and the logic active region contact hole CPHF may be referred to as a first contact hole and a second contact hole.

The word line contact hole CPHE may extend in (e.g., pass through) the second interlayer insulation layer 174, the first interlayer insulation layer 172, the second insulation layer pattern 114, the first insulation layer pattern 112, the buried insulation layer 124, and the upper word line layer 120b and may extend up to the lower word line layer 120a. In some embodiments, the word line contact hole CPHE may extend to the inner portion of the lower word line layer 120a. For example, the word line contact hole CPHE may extend in a portion (e.g., an upper portion) of the lower word line layer 120a.

The logic active region contact hole CPHF may extend in (e.g., pass through) the second interlayer insulation layer 174, the first interlayer insulation layer 172, the second insulation layer pattern 114, and the first insulation layer pattern 112 and may extend up to the logic active region 117. In some embodiments, the logic active region contact hole CPHF may extend to the inner portion of the logic active region 117. For example, the logic active region contact hole CPHF may extend in a portion (e.g., an upper portion) of the logic active region 117.

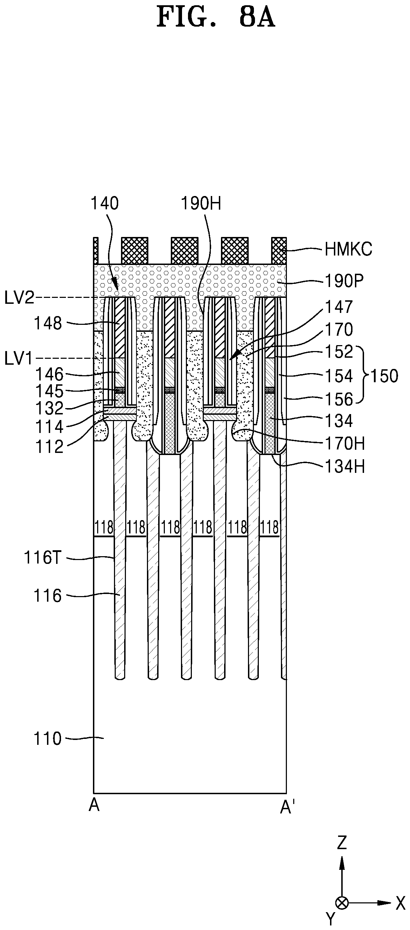

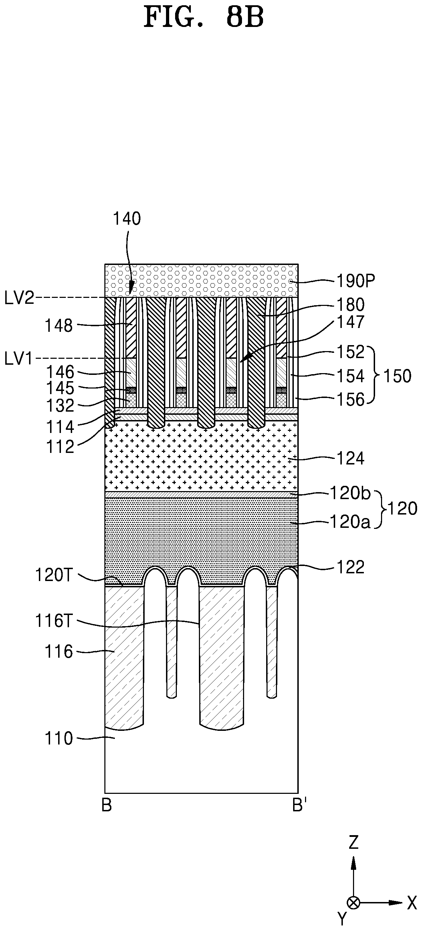

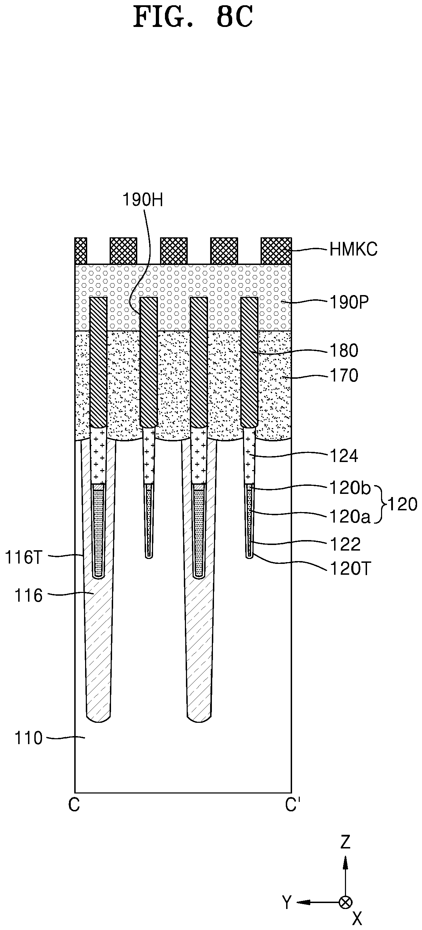

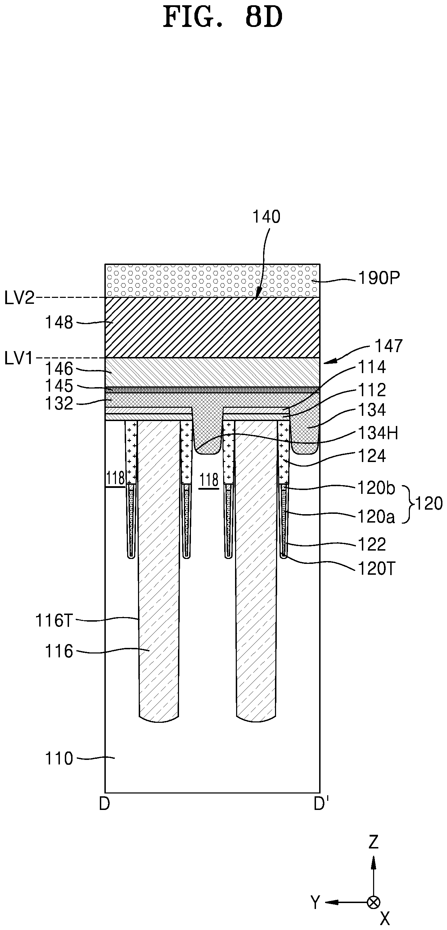

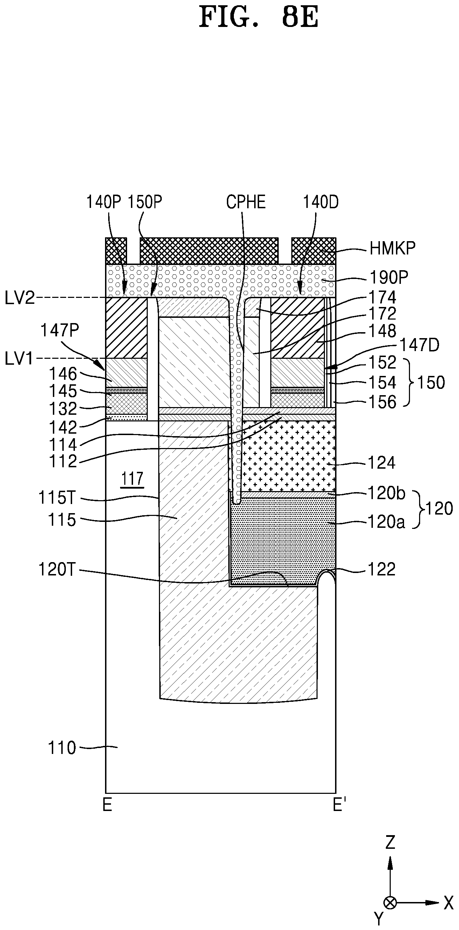

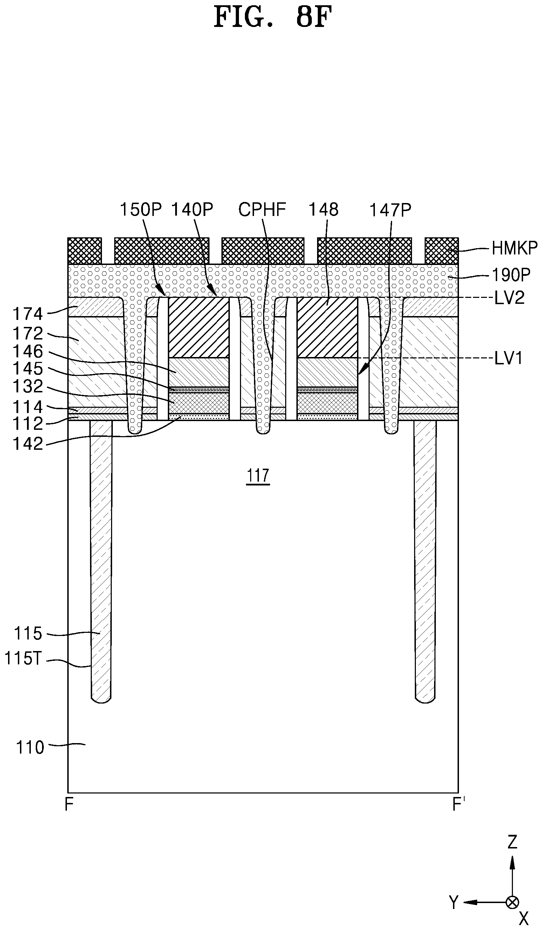

Referring to FIGS. 8A to 8F, a landing pad material layer 190P, which (at least partially) fills the plurality of landing pad holes 190H, the word line contact hole CPHE, and the logic active region contact hole CPHF and is on (e.g., covers or overlaps in the third direction) the plurality of bit line structures 140, the plurality of gate line structures 140P, and the (at least one) dummy bit line structure 140D, may be formed.

In some embodiments, an interface at which the buried contact 170 contacts the landing pad material layer 190P may be higher than a first vertical level LV1 of an upper surface of the second metal-group conductive pattern 146 and may be lower than a second vertical level LV2 of an upper surface of the insulation capping line 148.

In some embodiments, the landing pad material layer 190P may include a conductive barrier layer and a conductive pad material layer on the conductive barrier layer. For example, the conductive barrier layer may include metal, conductive metal nitride, and/or a combination thereof. In some embodiments, the conductive barrier layer may have, for example, a Ti/TiN stack structure. In some embodiments, the conductive pad material layer may include, for example, tungsten (W).

In some embodiments, before forming the landing pad material layer 190P, a metal silicide layer may be formed on the plurality of buried contacts 170. The metal silicide layer may be disposed between the landing pad material layer 190P and the plurality of buried contacts 170. The metal silicide layer may include, for example, cobalt silicide (CoSiₓ), nickel silicide (NiSiₓ), and/or manganese silicide (MnSiₓ) but is not limited thereto.

A cell hard mask pattern HMKC and a logic hard mask pattern HMKP may be formed on the landing pad material layer 190P. In some embodiments, the cell hard mask pattern HMKC and the logic hard mask pattern HMKP may be formed by an extreme ultraviolet (EUV) lithography process, but not limited thereto. The cell hard mask pattern HMKC and the logic hard mask pattern HMKP may be referred to as a plurality of hard mask patterns.

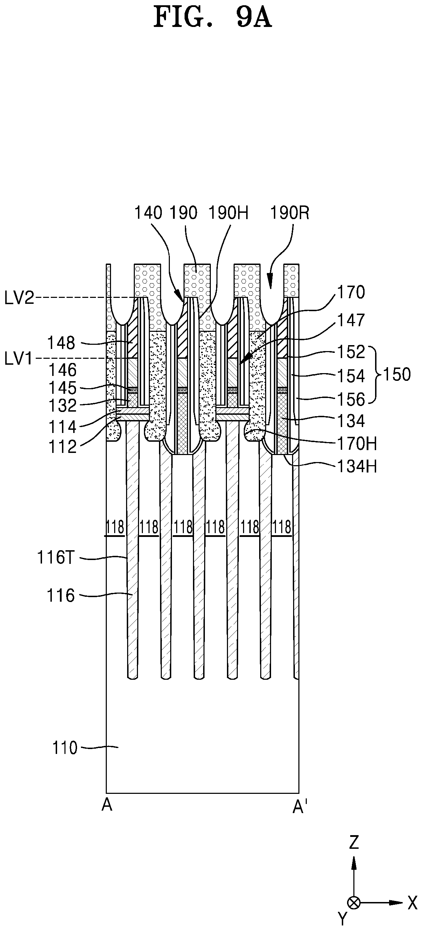

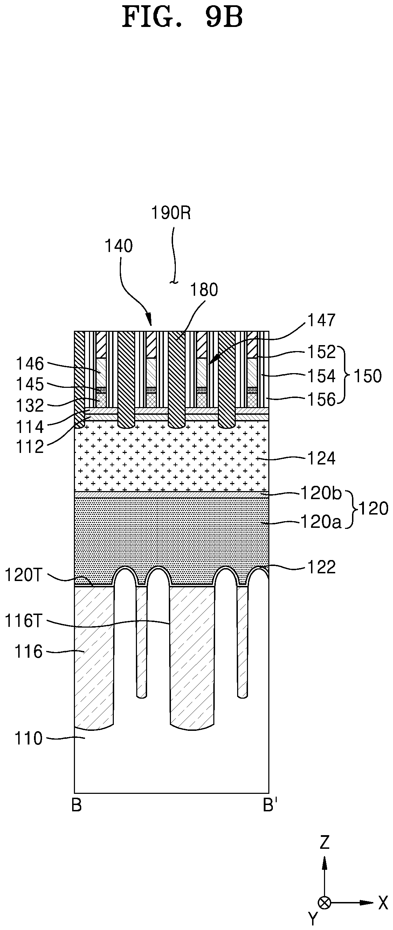

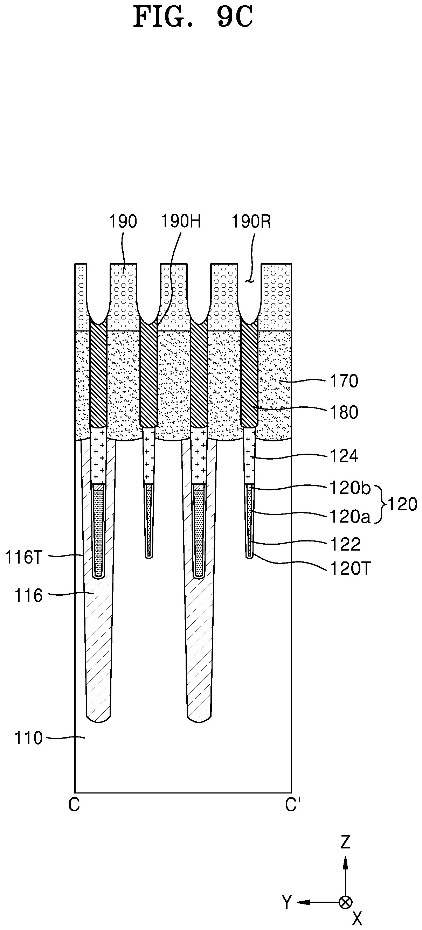

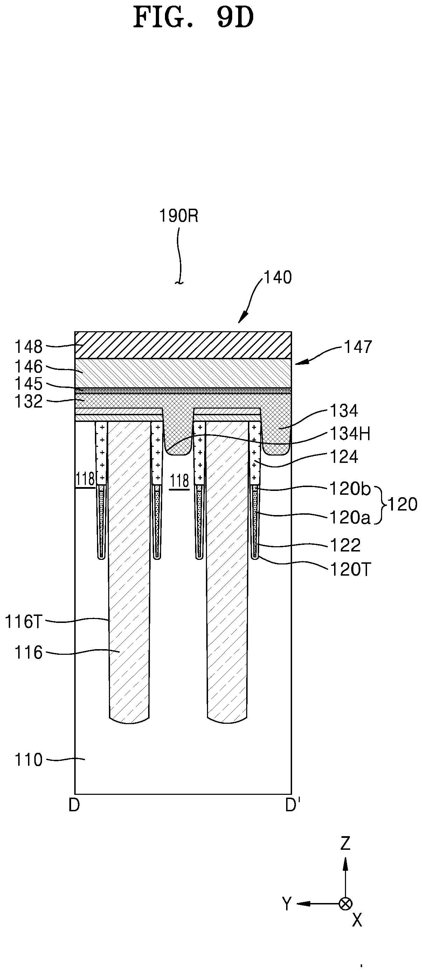

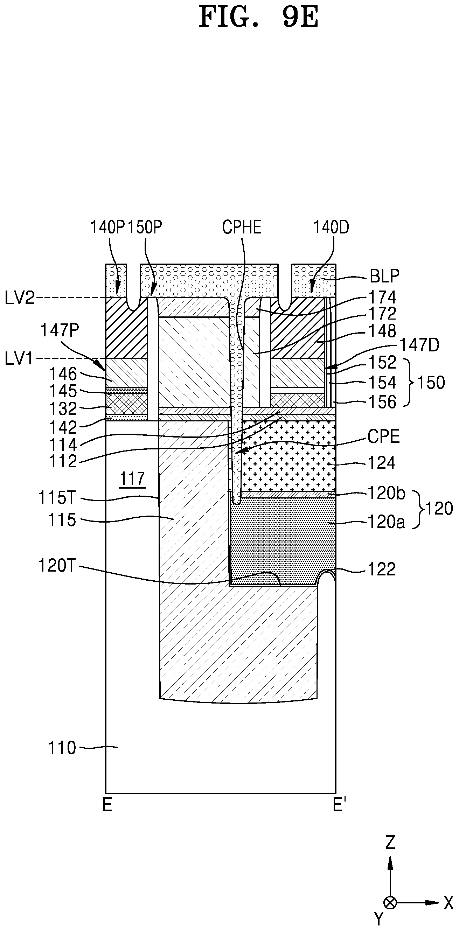

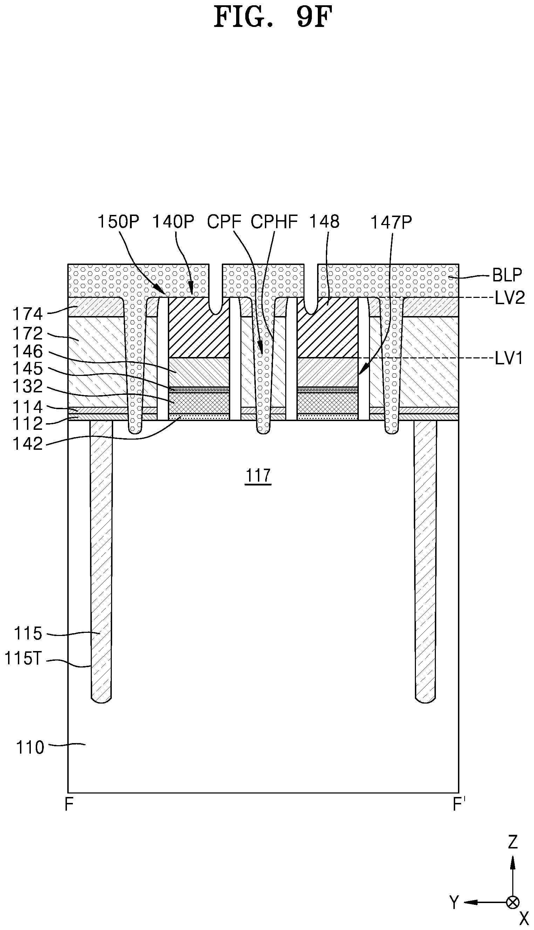

Referring to FIGS. 9A to 9F in conjunction with FIGS. 8A to 8F, a portion of the landing pad material layer 190P may be removed by using the cell hard mask pattern HMKC and the logic hard mask pattern HMKP as an etch mask, and thus, a plurality of landing pads 190, a plurality of logic bit lines BLP, a first contact plug CPE, and a second contact plug CPF may be formed. The plurality of landing pads 190 may fill at least partial portions of the plurality of landing pad holes 190H, extend to the plurality of bit line structures 140, and may be separated from one another by a recess portion 190R. The first contact plug CPE may (at least partially) fill the word line contact hole CPHE, and the second contact plug CPF may (at least partially) fill the logic active region contact hole CPHF.

The plurality of landing pads 190 may be apart from each other with the recess portion 190R therebetween. The plurality of landing pads 190 may be disposed on the plurality of buried contacts 170 and may extend to (toward) the plurality of bit line structures 140. In some embodiments, the plurality of landing pads 190 may extend to (toward) the plurality of bit lines 147. The plurality of landing pads 190 may be disposed on the plurality of buried contacts 170 and may be electrically connected to the plurality of buried contacts 170 corresponding to each other. The plurality of landing pads 190 may be connected (e.g., electrically connected) to the active region 118 through the plurality of buried contacts 170. The plurality of landing pads 190 may configure (e.g., may be) the plurality of landing pads LP illustrated in FIG. 2.

Each buried contact 170 may be disposed between two adjacent bit line structures 140, and each landing pad 190 may be on (e.g., may extend up to) one bit line structure 140 (among the two adjacent bit line structures 140) from a region between two bit line structures 140 adjacent to each other with the buried contact 170 therebetween. For example, each landing pad 190 may be on an upper surface of the buried contact 170 between the two adjacent bit line structures 140, a sidewall of one of the two adjacent bit line structures 140, and an upper surface of the one of the two adjacent bit line structures 140.

The logic bit line BLP may be disposed on the gate line structure 140P. For example, the logic bit line BLP may extend along a stack structure of the insulation capping line 148 of the gate line structure 140P and/or the first interlayer insulation layer 172 and the second interlayer insulation layer 174. The logic bit line BLP may extend on the gate line 147P. The logic bit line BLP may be a portion of the landing pad material layer 190P, which is higher than the second vertical level LV2. At least a portion of each of the plurality of landing pads 190 may be disposed at the same vertical level as the logic bit line BLP.

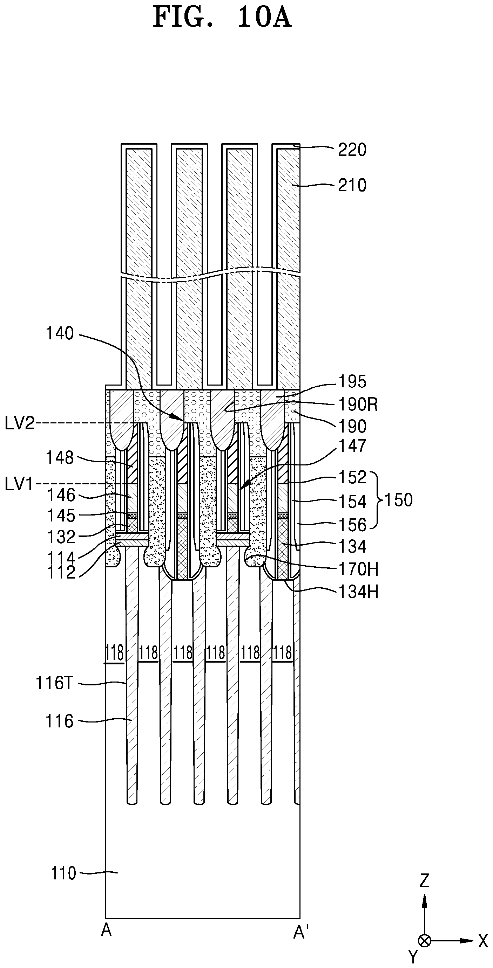

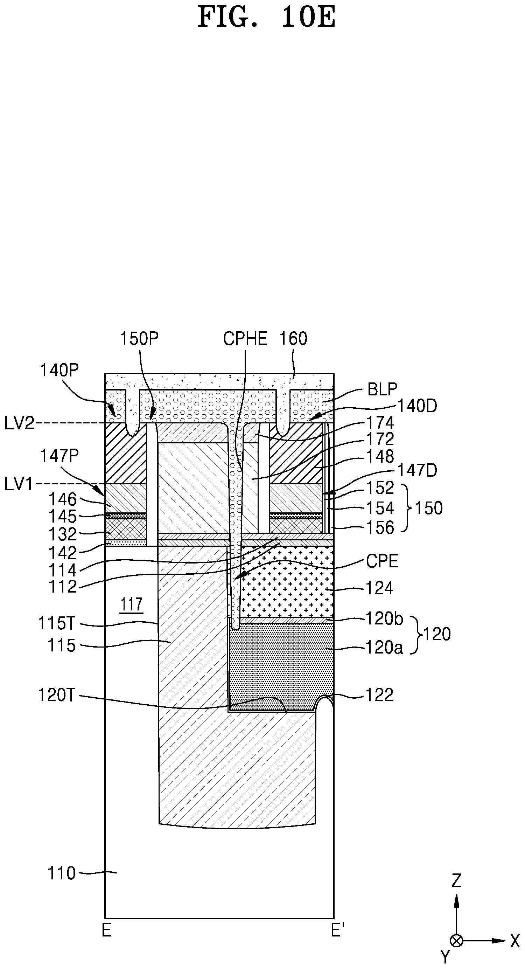

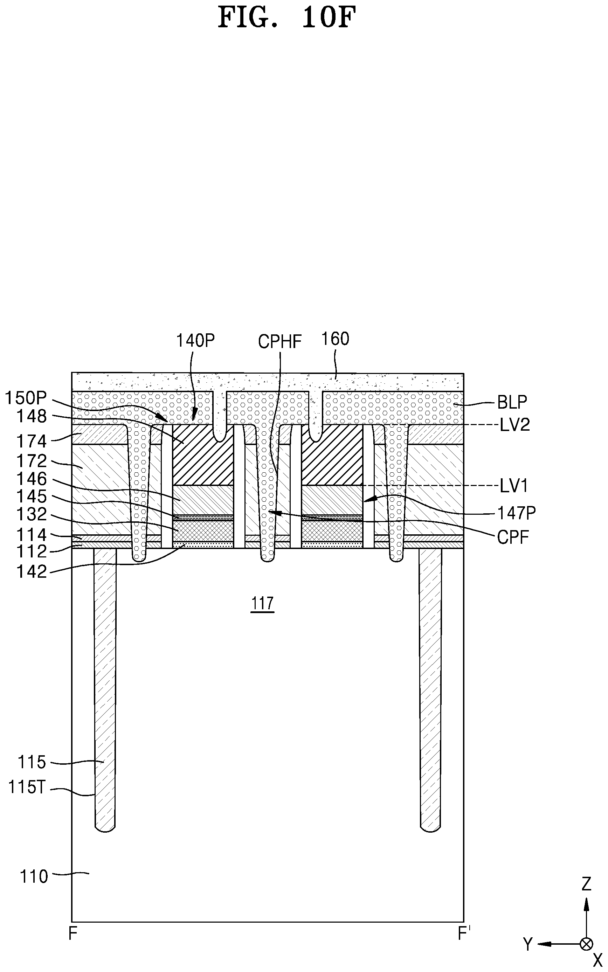

Referring to FIGS. 10A to 10F, a plurality of lower electrodes 210 and a capacitor dielectric layer 220 may be sequentially formed on the plurality of landing pads 190. Each of the plurality of lower electrodes 210 may be electrically connected to a corresponding landing pad 190 of the plurality of landing pads 190. The capacitor dielectric layer 220 may conformally cover a surface of each of the plurality of lower electrodes 210. The capacitor dielectric layer 220 may cover all, or only one or more, surfaces of each of the plurality of lower electrodes 210. For example, the capacitor dielectric layer 220 may be on a sidewall and an upper surface of the lower electrode 210. In some embodiments, the capacitor dielectric layer 220 may be provided as one body (e.g., a unitary structure) to cover the plurality of lower electrodes 210, in a certain region (for example, one memory cell region (CR of FIG. 2)). A unitary structure herein may refer to a structure without a visible boundary between two sub-elements thereof. In some other embodiments, the capacitor dielectric layer 220 may be formed to cover the memory cell region CR and a periphery region (PR of FIG. 2). The plurality of lower electrodes 210 may configure (e.g., may be) the plurality of storage nodes SN illustrated in FIG. 2.

Each of the plurality of lower electrodes 210 may have a pillar shape where an inner portion is filled to include a horizontal cross-sectional surface having a circular shape but is not limited thereto. In some embodiments, each of the plurality of lower electrodes 210 may have a cylinder shape where a lower portion is closed. In some embodiments, the plurality of lower electrodes 210 may be arranged in a honeycomb shape where the plurality of lower electrodes 210 are arranged in zigzags in the first horizontal direction (e.g., the X direction) and/or the second horizontal direction (e.g., the Y direction). In some other embodiments, the plurality of lower electrodes 210 may be arranged in a matrix form where the plurality of lower electrodes 210 are arranged in one row in each of the first horizontal direction (e.g., the X direction) and the second horizontal direction (e.g., the Y direction). The plurality of lower electrodes 210 may include, for example, impurity-doped silicon, metal such as tungsten or copper, or a conductive metal compound such as titanium nitride. In some embodiments, at least one supporting pattern contacting sidewalls of the plurality of lower electrodes 210 may be further formed. For example, a plurality of supporting patterns, which contact the sidewalls of the plurality of lower electrodes 210 and are arranged at different vertical levels, may be further formed.

The capacitor dielectric layer 220 may include, for example, TaO, TaAlO, TaON, AlO, AlSiO, HfO, HfSiO, ZrO, ZrSiO, TiO, TiAlO, BST((Ba,Sr)TiO), STO(SrTiO), BTO(BaTiO), PZT(Pb(Zr,Ti)O), (Pb,La)(Zr,Ti)O, Ba(Zr,Ti)O, Sr(Zr,Ti)O, or a combination thereof.

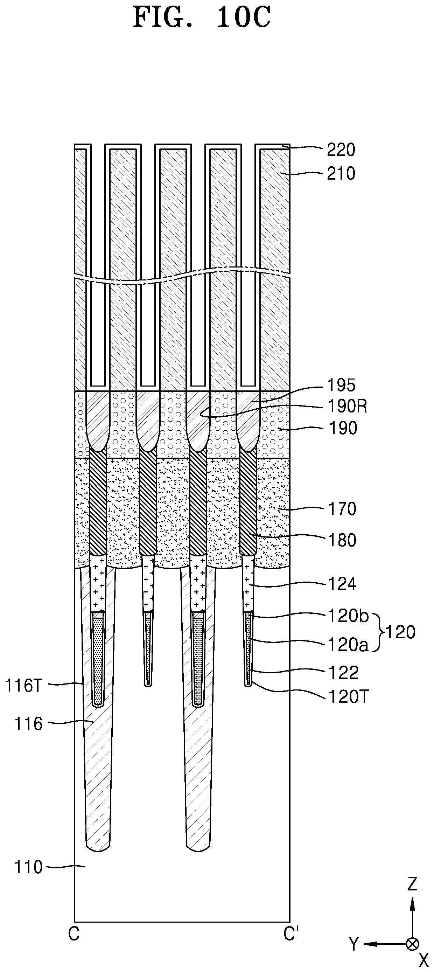

Before forming the plurality of lower electrodes 210, an insulation structure 195 (at least partially) filling the recess portion 190R may be formed. In some embodiments, the insulation structure 195 may have a stack structure of oxide and nitride. In FIGS. 10A and 10C, it is illustrated that an upper surface of the insulation structure 195 and a lower surface of the lower electrode 210 are disposed at the same level, but the inventive concept is not limited thereto.

Before forming the lower electrode 210 and the capacitor dielectric layer 220, a logic capping layer 160 on (e.g., covering or overlapping in the first horizontal direction and/or the third direction) the plurality of logic bit lines BLP may be formed. The logic capping layer 160 may include, for example, silicon oxide and/or silicon nitride. In some embodiments, the logic capping layer 160 may be formed on (e.g., to cover or overlap in the third direction) an upper surface of each of the plurality of logic bit lines BLP. In some other embodiments, the logic capping layer 160 may be formed (at least partially) to fill a space between every two adjacent logic bit lines BLP of the plurality of logic bit lines BLP and not to be on (e.g., not to cover in the third direction) the upper surface of each of the plurality of logic bit lines BLP.

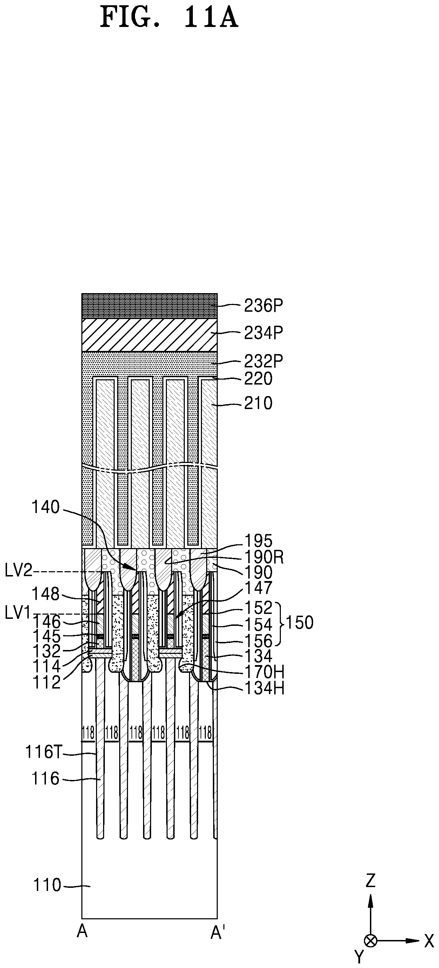

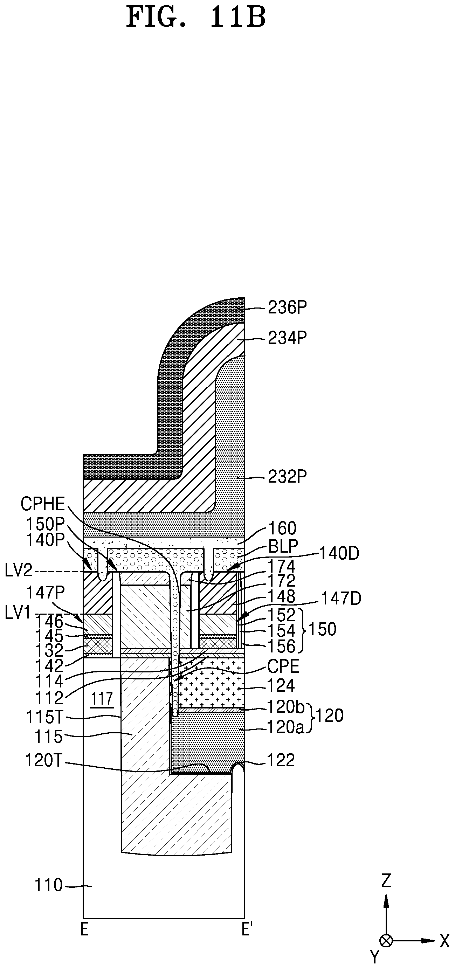

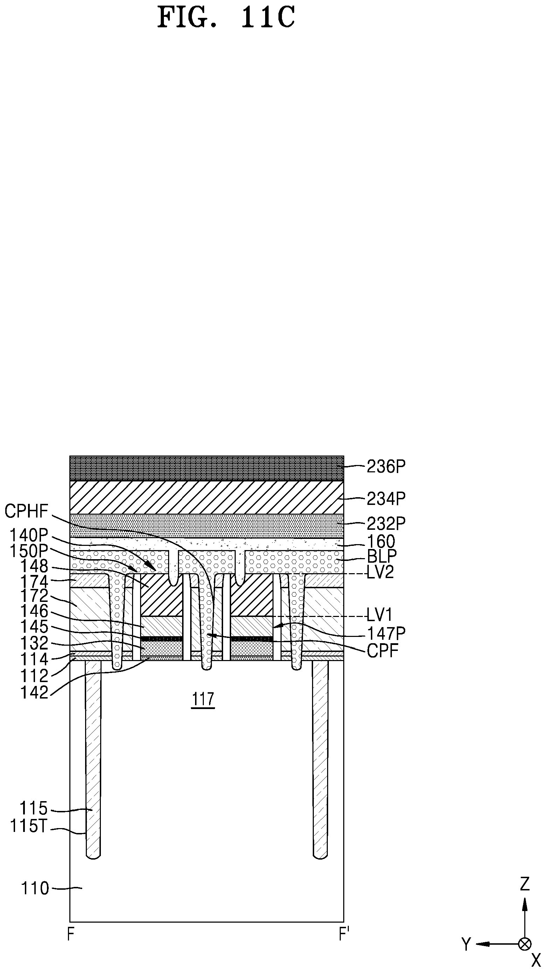

Referring to FIGS. 11A to 11C, a first upper electrode material layer 232P on (e.g., covering or overlapping) the capacitor dielectric layer 220 and the logic capping layer 160 may be formed. The first upper electrode material layer 232P may include, for example, a semiconductor material. In some embodiments, the first upper electrode material layer 232P may include, for example, polycrystalline silicon germanium (SiGe) and/or silicon. For example, the first upper electrode material layer 232P may include doped SiGe and/or doped polysilicon. The first upper electrode material layer 232P may be formed to fill all spaces between the plurality of lower electrodes 210. For example, the first upper electrode material layer 232P may be formed to have a thickness of (about) 500 Å to (about) 1,200 Å from an uppermost end of the capacitor dielectric layer 220.

A second upper electrode material layer 234P may be formed on the first upper electrode material layer 232P. The second upper electrode material layer 234P may include a metal-group material. For example, the second upper electrode material layer 234P may include metal. In some embodiments, the second upper electrode material layer 234P may include, for example, tungsten. In some embodiments, the second upper electrode material layer 234P may include, for example, a stack structure of a conductive barrier and a metal material layer on (e.g., covering or overlapping) the conductive barrier layer. The conductive barrier layer may include, for example, metal such as Ti or Ta and/or conductive metal nitride such as TiN, TaN, or WN. The metal material layer may include, for example, tungsten. For example, the second upper electrode material layer 234P may be formed to have a thickness of (about) 800 Å to (about) 1,200 Å (e.g., in the third direction). In some embodiments, the second upper electrode material layer 234P may include a stack structure of a metal-group material and an interface layer including, for example, metal oxide, metal nitride, metal carbide, and/or metal silicide. In some embodiments, the interface layer included in the second upper electrode material layer 234P may be formed to have a thickness of (about) 5 Å to (about) 50 Å (e.g., in the third direction).

A third upper electrode material layer 236P may be formed on the second upper electrode material layer 234P. The third upper electrode material layer 236P may include, for example, a semiconductor material. In some embodiments, the third upper electrode material layer 236P may include, for example, SiGe and/or silicon. For example, the third upper electrode material layer 236P may include doped SiGe and/or doped polysilicon. For example, the third upper electrode material layer 236P may be formed to have a thickness of (about) 400 Å to (about) 1,000 Å (e.g., in the third direction). In some embodiments, the third upper electrode material layer 236P may include the same material as that of the first upper electrode material layer 232P. For example, the first upper electrode material layer 232P and the third upper electrode material layer 236P may include SiGe.

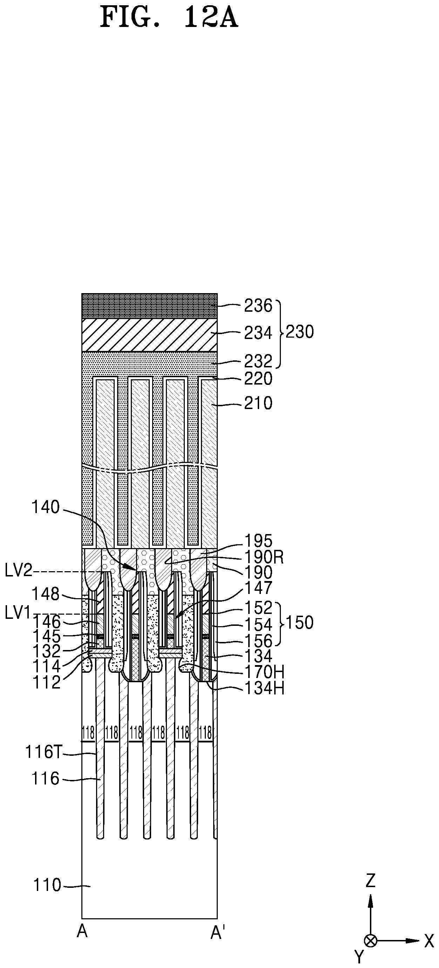

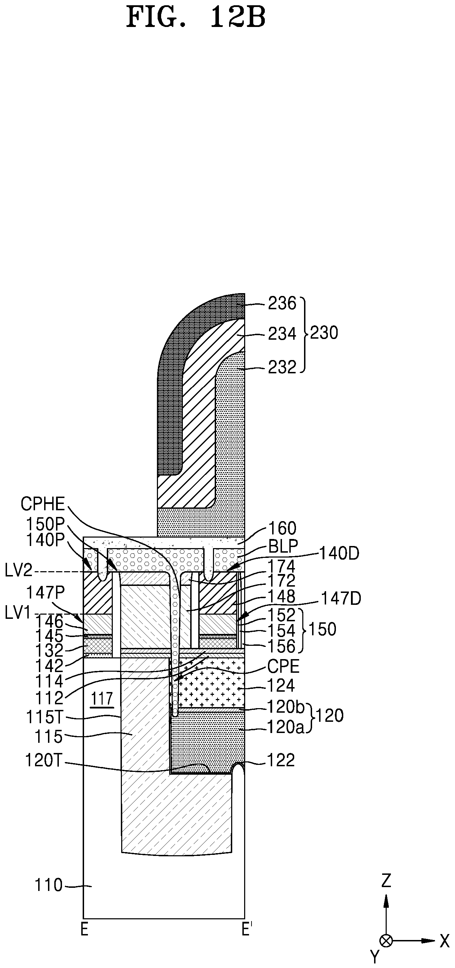

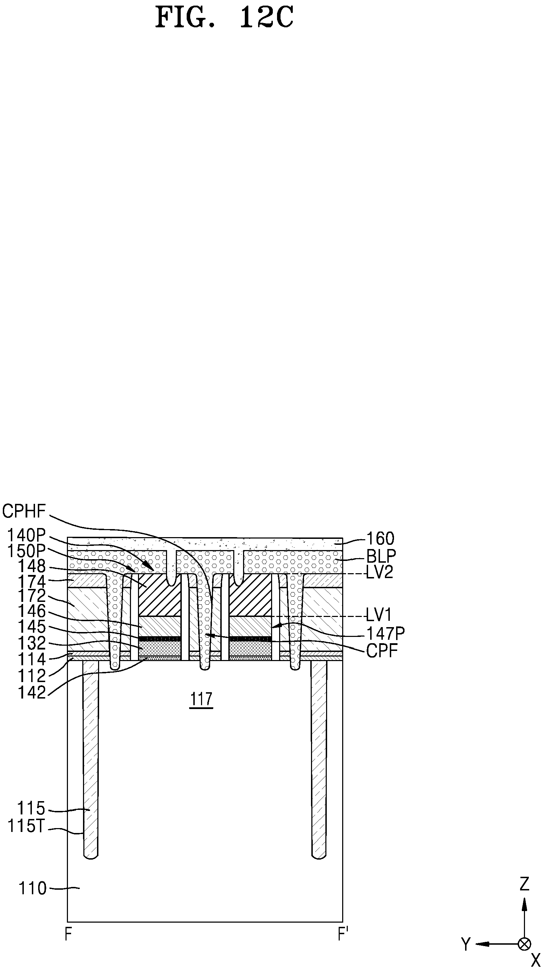

Referring to FIGS. 12A to 12C in conjunction with FIGS. 11A to 11C, a cell mask layer on (e.g., covering or overlapping in the third direction) a portion of the third upper electrode material layer 236P may be formed, and then, a third upper electrode layer 236, a second upper electrode layer 234, and a first upper electrode layer 232 may be formed by a portion of each of the third upper electrode material layer 236P, the second upper electrode material layer 234P, and the first upper electrode material layer 232P by using the cell mask layer as an etch mask. The first upper electrode layer 232, the second upper electrode layer 234, and the third upper electrode layer 236 may configure an upper electrode 230. The plurality of lower electrodes 210, the capacitor dielectric layer 220, and the upper electrode 230 may configure a plurality of capacitor structures 200.

The cell mask layer may include, for example, a resist material, or may have a stack structure of a hard mask material and a resist material. The cell mask layer may be on (e.g., cover or overlap in the third direction) a memory cell region (CR of FIG. 2) and may not be on (e.g., may not cover or overlap in the third direction) a periphery region (PR of FIG. 2). The plurality of capacitor structures 200 may be formed, and then, the cell mask layer may be removed. The capacitor structure 200 may not be formed in the periphery region (PR of FIG. 2), and the logic capping layer 160 may be exposed.

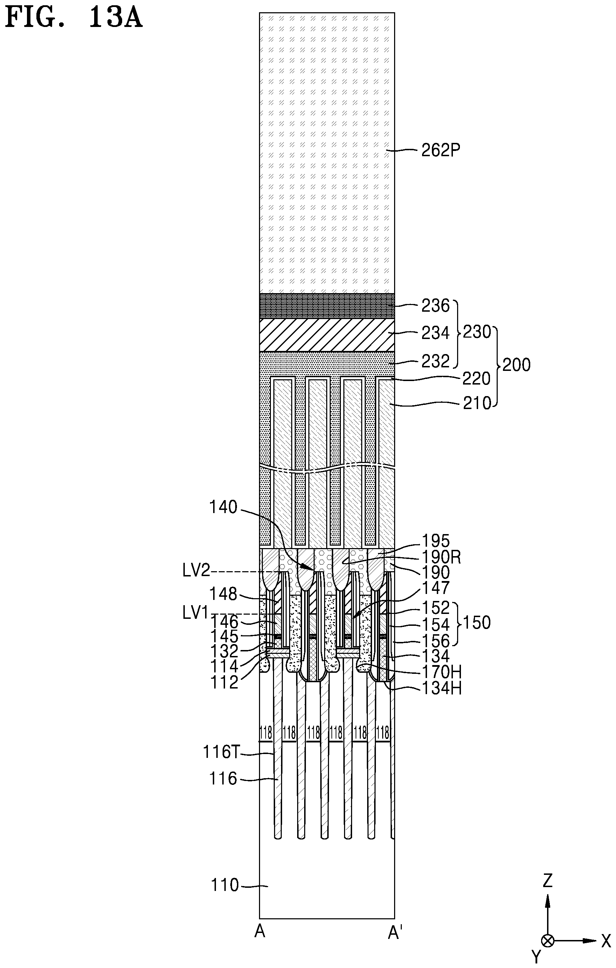

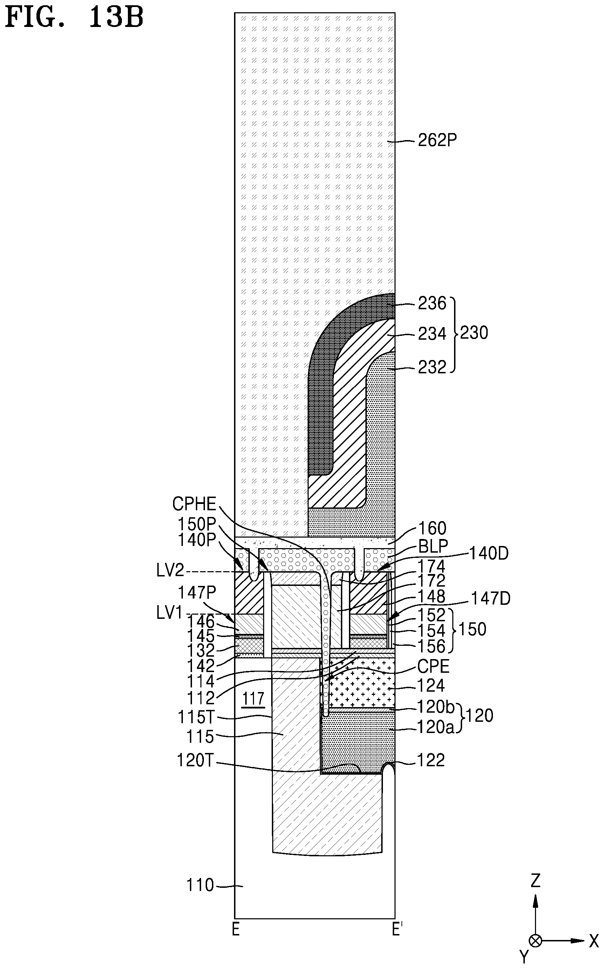

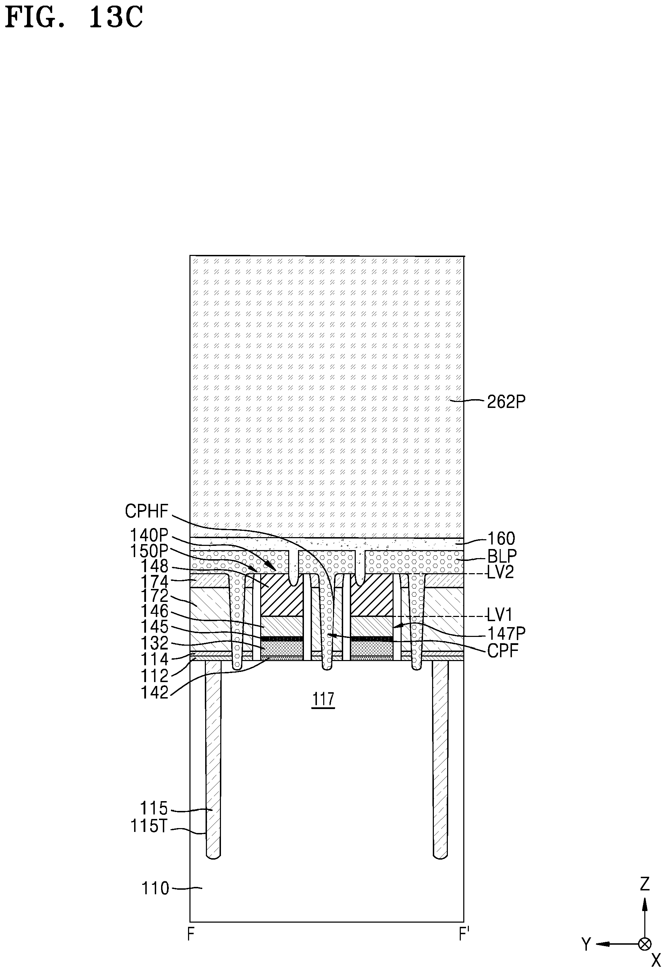

Referring FIGS. 13A to 13C, a buried insulation material layer 262P on (e.g., covering or overlapping in the first horizontal direction and/or the third direction) the plurality of capacitor structures 200 and the logic capping layer 160 may be formed. The buried insulation material layer 262P may include, for example, silicon oxide. The buried insulation material layer 262P may be formed to have a sufficient thickness so as to cover (or overlap in the first horizontal direction and/or the third direction) all of the plurality of capacitor structures 200. For example, the buried insulation material layer 262P may be formed to include an upper surface at a level which is higher than an uppermost end of the upper electrode 230.

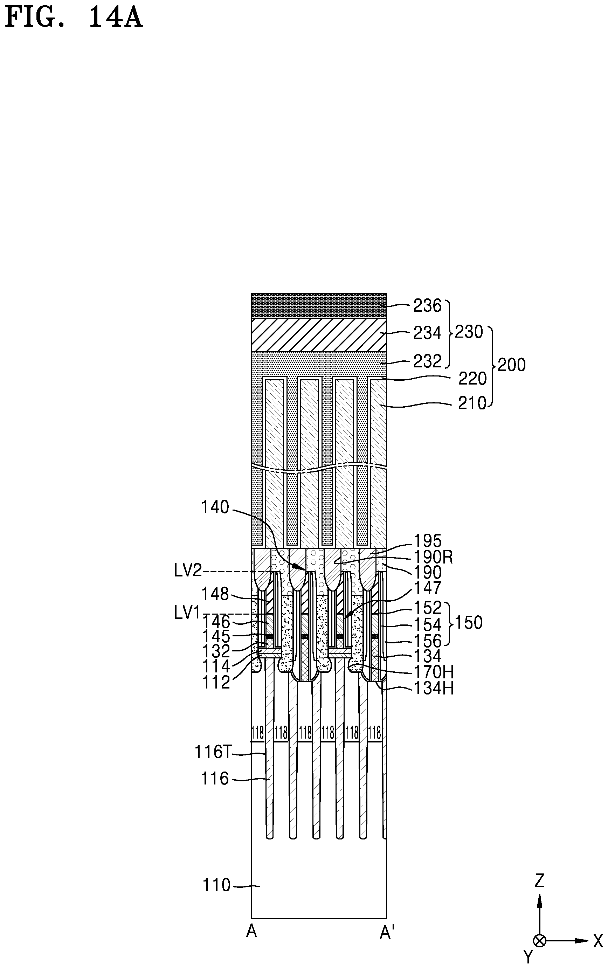

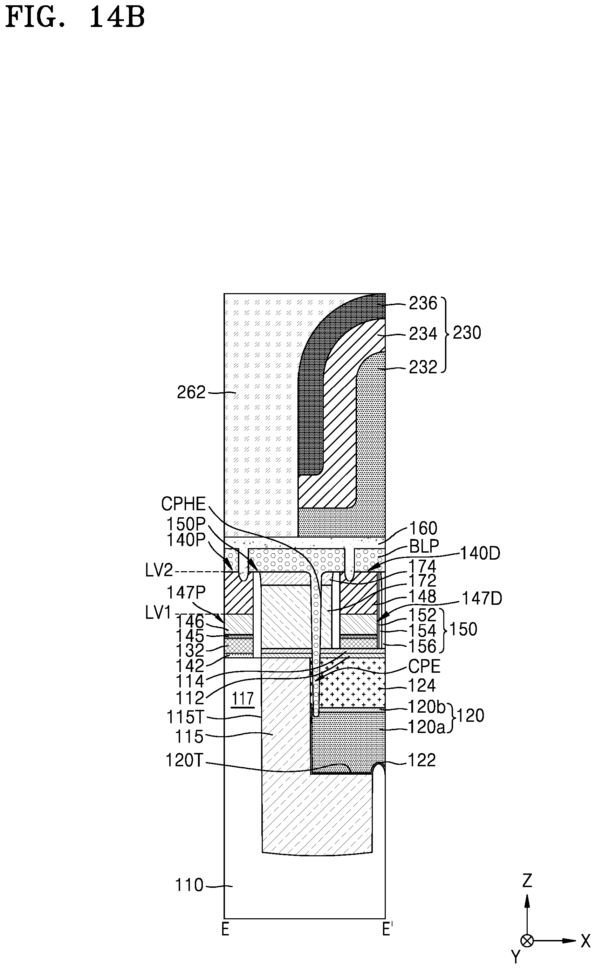

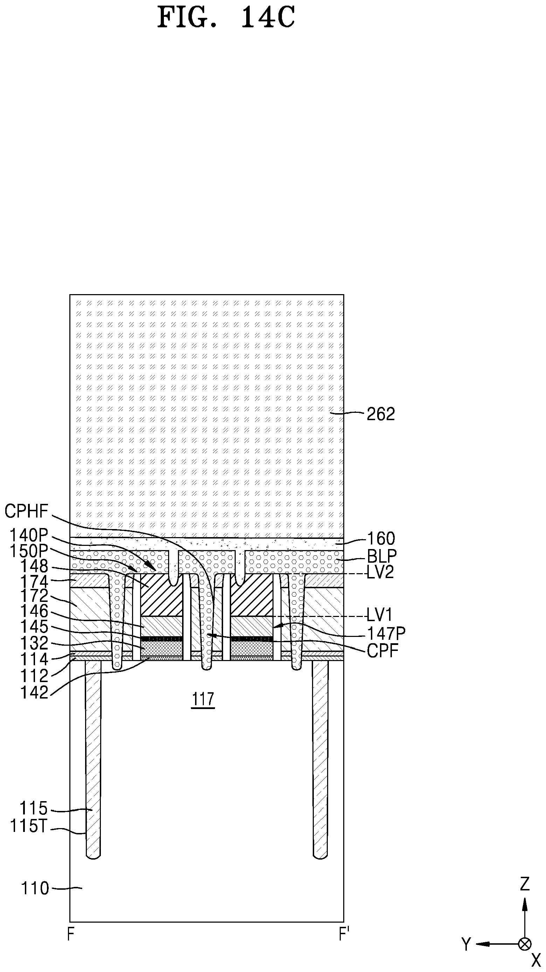

Referring to FIGS. 14A to 14C in conjunction with FIGS. 13A to 13C, a buried insulation layer 262 may be formed by removing a portion of an upper side of the buried insulation material layer 262P. The buried insulation layer 262 may be formed by removing a portion of the buried insulation material layer 262P at a level that is higher than the uppermost end of the upper electrode 230 (e.g., an upper end of the third upper electrode layer 236). For example, by performing a chemical mechanical polishing (CMP) process which uses the third upper electrode layer 236 as a process stopper, a portion of an upper side of the buried insulation material layer 262P may be removed, and thus, the buried insulation layer 262 may be formed. The buried insulation layer 262 may contact the upper electrode 230. For example, a side surface of the buried insulation layer 262 may directly contact each of the first upper electrode layer 232, the second upper electrode layer 234, and the third upper electrode layer 236. An upper surface of the buried insulation layer 262 and an uppermost surface of the upper electrode 230 (i.e., the upper surface of the buried insulation layer 262 and an uppermost surface of the third upper electrode layer 236) may be disposed at the same vertical level to configure a coplanar surface.

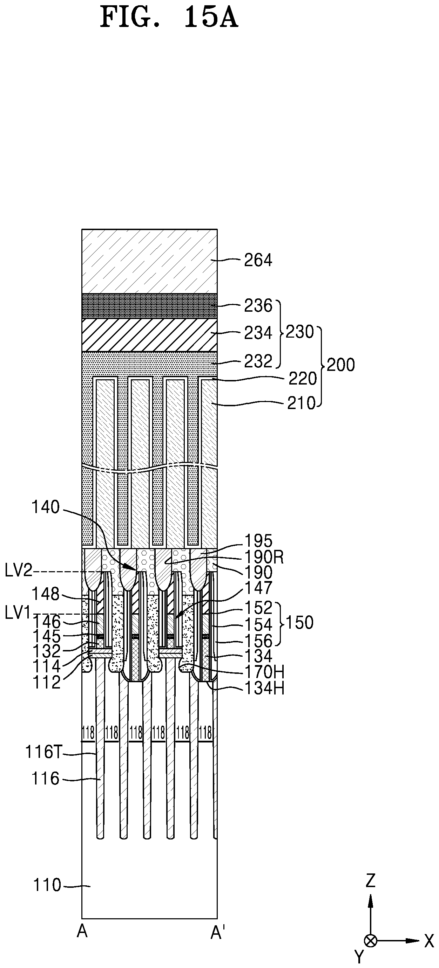

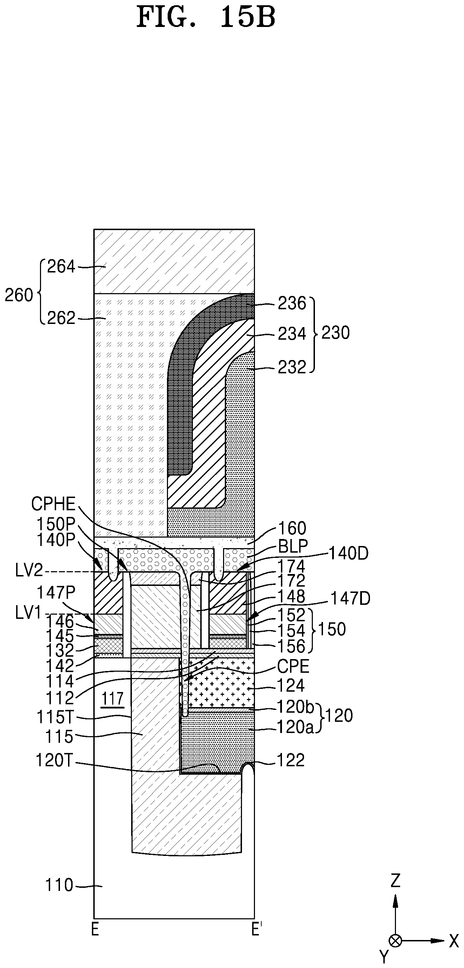

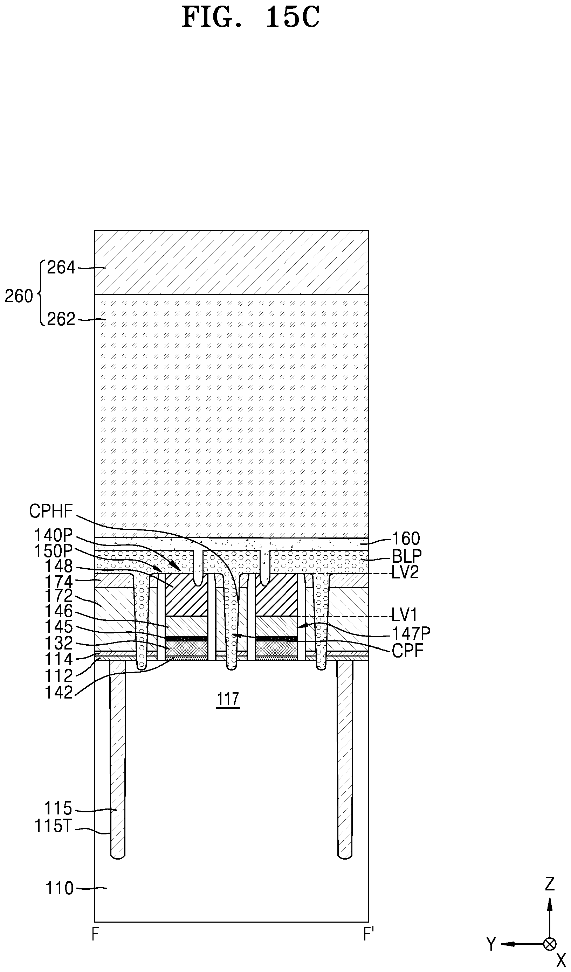

Referring to FIGS. 15A to 15C, a cover insulation layer 264 on (e.g., covering or overlapping in the third direction) the buried insulation layer 262 and the upper electrode 230 may be formed. A lower surface of the cover insulation layer 264 may directly contact an upper surface of the upper electrode 230, for example, an upper surface of the third upper electrode layer 236, and the upper surface of the buried insulation layer 262. The buried insulation layer 262 and the cover insulation layer 264 may configure a charge insulation layer 260. A portion, which is under an uppermost end of the upper electrode 230 (i.e., an uppermost end of the third upper electrode layer 236), of the charge insulation layer 260 may be the buried insulation layer 262, and a portion, which is on the uppermost end of the upper electrode 230, of the charge insulation layer 260 may be the cover insulation layer 264. The cover insulation layer 264 may include, for example, silicon oxide. In some embodiments, the buried insulation layer 262 and the cover insulation layer 264 may include the same material. The buried insulation layer 262 and the cover insulation layer 264 may include, for example, an oxide film and/or an ultra low-K (ULK) film. The oxide film may include, for example, boro-phospho-silicate glass (BPSG), phosphosilicate glass (PSG), borosilicate glass (BSG), undoped silicate glass (USG), tetra-ethyl-ortho-silicate (TEOS), and/or high density plasma (HDP) films. The ULK film may include, for example, a SiOC film and/or a SiCOH film each having a dielectric constant of (about) 2.2 to (about) 2.4.

Referring to FIGS. 16A to 16C, by removing a portion of the charge insulation layer 260, a plurality of wiring contact holes including a first wiring contact hole MCH1 and a second wiring contact hole MCH2 may be formed. The upper electrode 230 may be exposed at (by) a lower surface of the first wiring contact hole MCH1. The first wiring contact hole MCH1 may extend in (e.g., pass through) the cover insulation layer 264 and may extend in (e.g., extend up to) the upper electrode 230. In some embodiments, the first wiring contact hole MCH1 may extend to an inner portion of the upper electrode 230. For example, the first wiring contact hole MCH1 may extend in a portion (e.g., an upper portion) of the upper electrode 230 (e.g., the third upper electrode layer 236). The third upper electrode layer 236 may be exposed at (by) the lower surface of the first wiring contact hole MCH1. In some embodiments, the first wiring contact hole MCH1 may extend to an inner portion of the third upper electrode layer 236. For example, the first wiring contact hole MCH1 may pass through the charge insulation layer 260 and may extend to the inner portion of the third upper electrode layer 236 but may not extend up to the second upper electrode layer 234. A vertical level of the lower surface of the first wiring contact hole MCH1 may be disposed at a vertical level which is lower than an uppermost end of the third upper electrode layer 236 and higher than an uppermost end of the second upper electrode layer 234.

The logic bit line BLP may be exposed at (by) the lower surface of the second wiring contact hole MCH2. The second wiring contact hole MCH2 may extend in (e.g., pass through) the charge insulation layer 260 and the logic capping layer 160 and may extend in (e.g., extend up to) the logic bit line BLP. For example, the second wiring contact hole MCH2 may extend in a portion (e.g., an upper portion) of the logic bit line BLP. In some embodiments, the second wiring contact hole MCH2 may extend to an inner portion of the logic bit line BLP.

A plurality of wiring contact plugs, which include a first wiring contact plug MC1 (at least partially) filling the first wiring contact hole MCH1 and a second wiring contact plug MC2 (at least partially) filling the second wiring contact hole MCH2, may be formed.

The first wiring contact plug MC1 may contact the third upper electrode layer 236 and may not contact the second upper electrode layer 234. In some embodiments, the first wiring contact plug MC1 may extend to an inner portion of the upper electrode 230. For example, the first wiring contact plug MC1 may pass through the charge insulation layer 260 and may extend to the inner portion of the third upper electrode layer 236 but may not extend up to the second upper electrode layer 234. A vertical level of a lower surface of the first wiring contact plug MC1 may be disposed at a vertical level that is lower than an uppermost end of the third upper electrode layer 236 and higher than an uppermost end of the second upper electrode layer 234.

The second wiring contact plug MC2 may pass through the charge insulation layer 260 and the logic capping layer 160 and may extend up to the logic bit line BLP. In some embodiments, the second wiring contact plug MC2 may extend to an inner portion of the logic bit line BLP.

Each of the first wiring contact plug MC1 and the second wiring contact plug MC2 may include a wiring contact conductive layer 310 which may include a wiring contact barrier layer 312 and a wiring contact charge layer 314. The wiring contact barrier layer 312 may be formed on (e.g., to conformally cover) an inner surface (e.g., a sidewall and a lower surface) of each of the first wiring contact hole MCH1 and the second wiring contact hole MCH2, and the wiring contact charge layer 314 may be formed on (e.g., to cover) the wiring contact barrier layer 312 and (at least partially) fill each of the first wiring contact hole MCH1 and the second wiring contact hole MCH2. For example, the wiring contact barrier layer 312 may include Ti, Ta, TiN, and/or TaN. For example, the wiring contact charge layer 314 may include metal such as W.

A plurality of wiring lines 320 connected (e.g., electrically connected) to the first wiring contact plug MC1 and the second wiring contact plug MC2 may be formed on the charge insulation layer 260 where the first wiring contact plug MC1 and the second wiring contact plug MC2 are formed, and thus, the semiconductor memory device 1 may be manufactured. The plurality of wiring lines 320 may include, for example, metal such as aluminum (Al), Cu, or W.

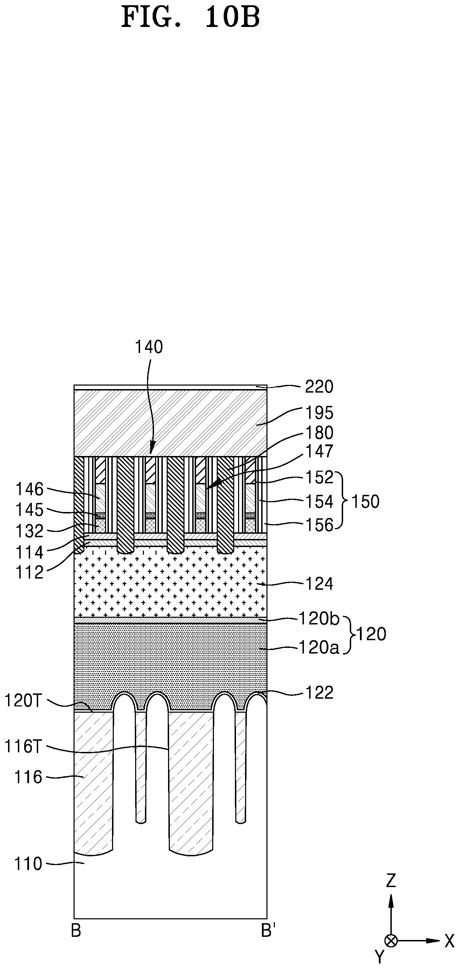

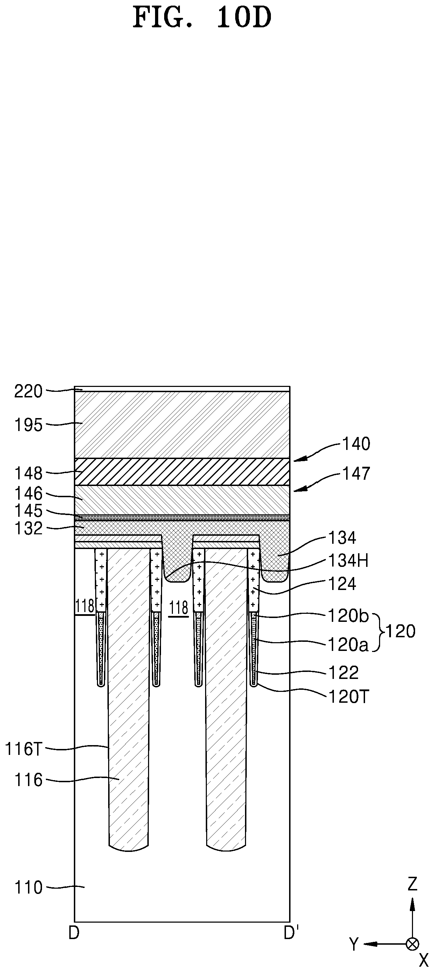

In FIGS. 16A to 16C, a cross-sectional view taken along a position corresponding to line B-B' of FIG. 2, a cross-sectional view taken along a position corresponding to line C-C' of FIG. 2, and a cross-sectional view taken along a position corresponding to line D-D' of FIG. 2 are not separately illustrated, but elements under the first upper electrode layer 232 may be substantially the same as the illustrations of FIGS. 10B, 10C, and 10D and may thus refer to FIGS. 10B, 10C, and 10D.

A semiconductor memory device 1 may include a substrate 110 including a plurality of active regions 118 and a plurality of logic active regions 117, a plurality of gate dielectric layers 122, a plurality of word lines 120, and a plurality of buried insulation layers 124 which are sequentially formed in a plurality of word line trenches 120T on (e.g., crossing or overlapping in the third direction) the plurality of active regions 118 in the substrate 110, a stack structure of a first insulation layer pattern 112 and a second insulation layer pattern 114 each on (e.g., covering or overlapping in the third direction) a device isolation layer 116, the plurality of active regions 118, and the plurality of buried insulation layers 124, a plurality of bit line structures 140 on the stack structure of the first insulation layer pattern 112 and the second insulation layer pattern 114, a plurality of insulation spacer structures 150 covering both sidewalls of each of the plurality of bit line structures 140, a plurality of gate line structures 140P on the plurality of logic active regions 117, a plurality of gate insulation spacers 150P on (e.g., covering or overlapping in the first horizontal direction) both (e.g., opposite in the first horizontal direction) sidewalls of each of the plurality of gate line structures 140P, a plurality of buried contacts 170 which (at least partially) fill a lower portion of a space defined by a plurality of insulation fences 180 and the plurality of insulation spacer structures 150 and are connected (e.g., electrically connected) to the plurality of active regions 118, a plurality of landing pads 190 which (at least partially) fill an upper portion of the space and extend to an upper portion of the bit line structure 140, a plurality of capacitor structures 200 which each include a plurality of lower electrodes 210 connected (e.g., electrically connected) to the plurality of landing pads 190, a capacitor dielectric layer 220, and an upper electrode 230, a first wiring contact plug MC1 connected (e.g., electrically connected) to the upper electrode 230, and a second wiring contact plug MC2 connected (e.g., electrically connected) to a logic bit line BLP.

The upper electrode 230 may include a first upper electrode layer 232, a second upper electrode layer 234 on (e.g., covering or overlapping in the first horizontal direction and/or the third direction) the first upper electrode layer 232, and a third upper electrode layer 236 on (e.g., covering or overlapping in the first horizontal direction and/or the third direction) the second upper electrode layer 234. The first upper electrode layer 232 may be on (e.g., cover or overlap in the first horizontal direction and the third direction) the capacitor dielectric layer 220 and may be disposed in (e.g., may at least partially fill) a space between the plurality of lower electrodes 210.

In some embodiments, the first upper electrode layer 232 may include, for example, doped poly SiGe and/or doped polysilicon. In some embodiments, the second upper electrode layer 234 may include a stack structure of a conductive barrier and a metal material layer on (e.g., covering or overlapping) the conductive barrier layer. The conductive barrier layer may perform a function of an adhesive layer which attaches the second upper electrode layer 234 on the first upper electrode layer 232. The conductive barrier layer may include, for example, Ti, TiN, Ta, and/or TaN. In some embodiments, the conductive barrier layer may include, for example, Ti. The metal material layer may include, for example, W, Ru, RuO, Pt, PtO, Ir, IrO, SRO (SrRuO), BSRO ((Ba,Sr)RuO), CRO (CaRuO), BaRuO, and/or La(Sr,Co)O. In some embodiments, the metal material layer may include, for example, a metal material. In some embodiments, the metal material layer may include, for example, W. The third upper electrode layer 236 may include, for example, doped poly SiGe and/or doped polysilicon. In some embodiments, the third upper electrode layer 236 may include, for example, the same material as that of the first upper electrode layer 232. For example, the first upper electrode layer 232 and the third upper electrode layer 236 may include poly SiGe.

The semiconductor memory device 1 may further include a word line contact plug CPE and a logic active region contact plug CPF. The word line contact plug CPE may be referred to as the first contact plug CPE, and the logic active region contact plug CPF may be referred to as the second contact plug CPF. The word line contact plug CPE may extend in (e.g., pass through) the second interlayer insulation layer 174, the first interlayer insulation layer 172, the second insulation layer pattern 114, the first insulation layer pattern 112, the buried insulation layer 124, and the upper word line layer 120b and may be connected (e.g., electrically connected) to the lower word line layer 120a. For example, the word line contact plug CPE may extend in an upper portion of the lower word line layer 120a. The logic active region contact plug CPF may extend in (e.g., pass through) the second interlayer insulation layer 174, the first interlayer insulation layer 172, the second insulation layer pattern 114, and the first insulation layer pattern 112 and may be connected (e.g., electrically connected) to the logic active region 117. For example, the logic active region contact plug CPF may extend in an upper portion of the logic active region 117.

A plurality of logic bit lines BLP may be disposed on the insulation capping line 148 and the second interlayer insulation layer 174. In some embodiments, the logic bit line BLP may include a stack structure of Ti, TiN, or Ti/TiN and W.

The semiconductor memory device 1 may further include a first wiring contact hole MCH1 and a second wiring contact hole MCH2. The second wiring contact plug MC2 may have a vertical height having a value which is greater than that of the first wiring contact plug MC1. For example, the second wiring contact plug MC2 may have greater height than the first wiring contact plug MC1 in the third direction (e.g., the Z direction). For example, an upper surface of the first wiring contact plug MC1 and an upper surface of the second wiring contact plug MC2 may be disposed at the same vertical level, and a lower surface of the first wiring contact plug MC1 may be disposed at a vertical level which is higher than a lower surface of the second wiring contact plug MC2. The first wiring contact plug MC1 may electrically connect the wiring line 320 to the upper electrode 230. The second wiring contact plug MC2 may electrically connect the wiring line 320 to the logic bit line BLP. In some embodiments, the second wiring contact plug MC2 and the logic bit line BLP connected to the second wiring contact plug MC2 may electrically connect the wiring line 320 to the gate line 147P, connect (e.g., electrically connect) the wiring line 320 to the word line 120, or connect (e.g., electrically connect) the wiring line 320 to the logic active region 117.

The first wiring contact plug MC1 may extend in (e.g., pass through) the charge insulation layer 260 (i.e., the cover insulation layer 264) and may extend up to the third upper electrode layer 236. For example, the first wiring contact plug MC1 may extend to (extend in) an inner portion (e.g., an upper portion) of the third upper electrode layer 236. In some embodiments, the first wiring contact plug MC1 may include a lower surface disposed at a vertical level that is higher than an uppermost end of the second upper electrode layer 234, so that first wiring contact plug MC1 is apart from the second upper electrode layer 234 without contacting each other.

The second wiring contact plug MC2 may extend in (e.g., pass through) the charge insulation layer 260 (i.e., the cover insulation layer 264 and the buried insulation layer 262) and the logic capping layer 160 and may extend up to the logic bit line BLP. For example, the second wiring contact plug MC2 may extend to (extend in) an inner portion (e.g., an upper portion) of the logic bit line BLP.

Referring to FIGS. 3A to 16C, in the semiconductor memory device 1 according to an embodiment, the buried insulation layer 262 may be formed by performing a CMP process by using the third upper electrode layer 236 as a process stopper. The semiconductor memory device 1 according to an embodiment may not include a separate etch stop layer on (e.g., covering) the upper electrode 230. For example, the semiconductor memory device 1 may not include a layer including nitride between the upper electrode 230 and the charge insulation layer 260. Accordingly, in a process of forming the first wiring contact hole MCH1 and the second wiring contact hole MCH2, it may not be needed to pass through the separate etch stop layer, and thus, the level of difficulty of a process of forming the semiconductor memory device 1 may be reduced. Moreover, because the level of difficulty of a process is reduced, the occurrence of a defect such as "not open" may be reduced (e.g., prevented) in a process of forming the first wiring contact hole MCH1 and the second wiring contact hole MCH2, and thus, electrical connection reliability between the first wiring contact plug MC1 and the upper electrode 230 and electrical connection reliability between the second wiring contact plug MC2 and the logic bit line BLP may be enhanced, thereby securing the reliability of the semiconductor memory device 1.

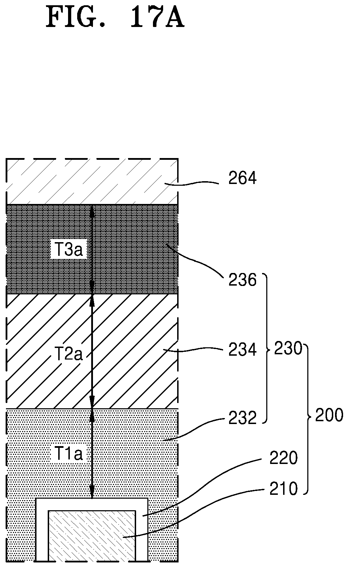

FIGS. 17A to 17C are enlarged cross-sectional views of a semiconductor memory device according to example embodiments. In detail, FIGS. 17A to 17C are enlarged cross-sectional views of a region XVII of FIG. 16A.

Referring to FIG. 17A, a capacitor structure 200 may include a lower electrode 210, a capacitor dielectric layer 220, and an upper electrode 230. The upper electrode 230 may have a stack structure of a first upper electrode layer 232, a second upper electrode layer 234, and a third upper electrode layer 236.

The first upper electrode layer 232 may have a first thickness T1a in the vertical direction (e.g., the third direction or the Z direction) from an uppermost end of the capacitor dielectric layer 220. The second upper electrode layer 234 may have a second thickness T2a in the vertical direction (e.g., the third direction or the Z direction). The third upper electrode layer 236 may have a third thickness T3a in the vertical direction (e.g., the third direction or the Z direction). The second thickness T2a may have a value which is greater than that of each of the first thickness T1a and the third thickness T3a. For example, the second thickness T2a may be (about) 800 Å to (about) 1,200 Å. In some embodiments, the first thickness T1a and the third thickness T3a may have (substantially) the same value. For example, each of the first thickness T1a and the third thickness T3a may be (about) 500 Å to (about) 1,000 Å.

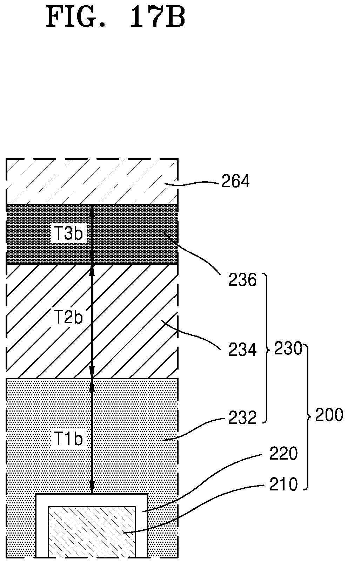

Referring to FIG. 17B, a capacitor structure 200 may include a lower electrode 210, a capacitor dielectric layer 220, and an upper electrode 230. The upper electrode 230 may have a stack structure of a first upper electrode layer 232, a second upper electrode layer 234, and a third upper electrode layer 236.

The first upper electrode layer 232 may have a first thickness T1b in the vertical direction (e.g., the third direction or the Z direction) from an uppermost end of the capacitor dielectric layer 220. The second upper electrode layer 234 may have a second thickness T2b in the vertical direction (e.g., the third direction or the Z direction). The third upper electrode layer 236 may have a third thickness T3b in the vertical direction (e.g., the third direction or the Z direction). The first thickness T1b may have a value which is greater than that of the third thickness T3b. The second thickness T2b may have a value which is greater than that of the third thickness T3b. For example, the second thickness T2b may be (about) 800 Å to (about) 1,200 Å. The first thickness T1b may have a value which is greater than that of the third thickness T3b. In some embodiments, the first thickness T1b and the second thickness T2b may have (substantially) the same value. For example, the first thickness T1b may be (about) 800 Å to (about) 1,200 Å. For example, the third thickness T3b may be (about) 400 Å to (about) 1,000 Å.

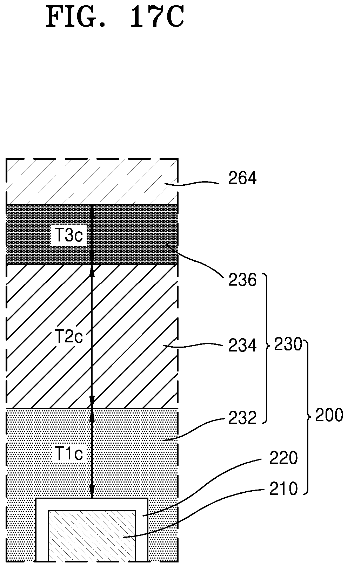

Referring to FIG. 17C, a capacitor structure 200 may include a lower electrode 210, a capacitor dielectric layer 220, and an upper electrode 230. The upper electrode 230 may have a stack structure of a first upper electrode layer 232, a second upper electrode layer 234, and a third upper electrode layer 236.

The first upper electrode layer 232 may have a first thickness T1c in the vertical direction (e.g., the third direction or the Z direction) from an uppermost end of the capacitor dielectric layer 220. The second upper electrode layer 234 may have a second thickness T2c in the vertical direction (e.g., the third direction or the Z direction). The third upper electrode layer 236 may have a third thickness T3c in the vertical direction (e.g., the third direction or the Z direction). The second thickness T2c may have a value which is greater than that of the first thickness T1c. The first thickness T1c may have a value which is greater than that of the third thickness T3c. For example, the second thickness T2c may be (about) 900 Å to (about) 1,200 Å. For example, the first thickness T1c may be (about) 800 Å to (about) 1,000 Å. For example, the third thickness T3c may be (about) 400 Å to (about) 900 Å.

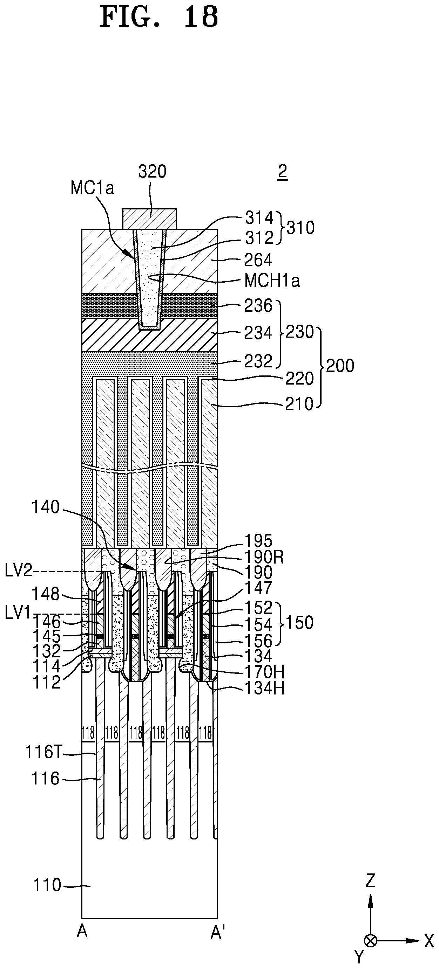

FIG. 18 is a cross-sectional view illustrating a semiconductor memory device 2 according to example embodiments.

Referring to FIG. 18, the semiconductor memory device 2 may include a first wiring contact plug MC1a (at least partially) filling a first wiring contact hole MCH1a, instead of the first wiring contact plug MC1 (at least partially) filling the first wiring contact hole MCH1 included in the semiconductor memory device 1 illustrated in FIGS. 16A to 16C.

An upper electrode 230 may be exposed at (exposed by) a lower surface of the first wiring contact hole MCH1a. The first wiring contact hole MCH1a may extend in (e.g., pass through) a cover insulation layer 264 and may extend up to the upper electrode 230. In some embodiments, the first wiring contact hole MCH1a may extend to (extend in) an inner portion (e.g., an upper portion) of the upper electrode 230. The second upper electrode layer 234 may be exposed at (exposed by) a lower surface of the first wiring contact hole MCH1a. In some embodiments, the first wiring contact hole MCH1a may extend to (extend in) an inner portion (e.g., an upper portion) of the second upper electrode layer 234. For example, the first wiring contact hole MCH1a may extend in (e.g., pass through) the charge insulation layer 260 (e.g., the cover insulation layer 264) and the third upper electrode layer 236 and may extend to (extend in) the inner portion (e.g., an upper portion) of the second upper electrode layer 234 but may not extend up to (extend in) the first upper electrode layer 232. A vertical level of a lower surface of the first wiring contact hole MCH1a may be disposed at a vertical level which is lower than an uppermost end of the second upper electrode layer 234 and higher than an uppermost end of the first upper electrode layer 232.

The first wiring contact plug MC1a may electrically connect the wiring line 320 to the upper electrode 230. The first wiring contact plug MC1a may extend in (e.g., pass through) the charge insulation layer 260 (i.e., the cover insulation layer 264) and the third upper electrode layer 236 and may extend up to (extend in) the second upper electrode layer 234. For example, the first wiring contact plug MC1a may extend to (extend in) an inner portion (e.g., an upper portion) of the second upper electrode layer 234. In some embodiments, the first wiring contact plug MC1a may include a lower surface disposed at a vertical level which is higher than an uppermost end of the first upper electrode layer 232 and lower than an uppermost end of the second upper electrode layer 234, so that first wiring contact plug MC1a is apart from the first upper electrode layer 232 without contacting each other.

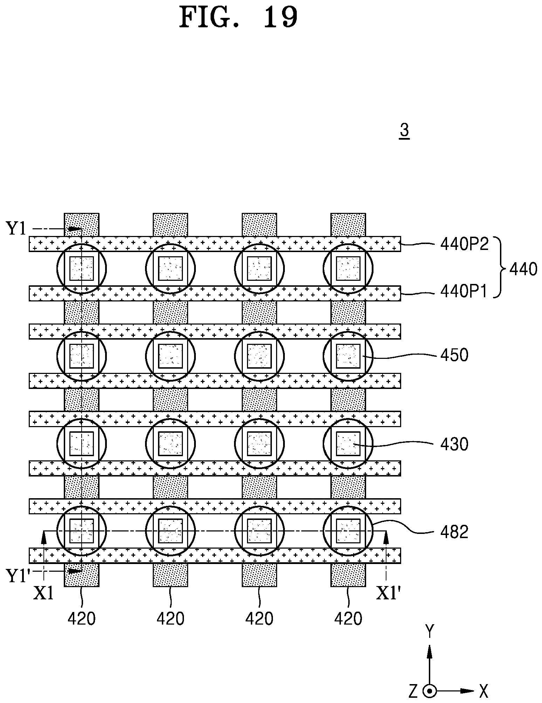

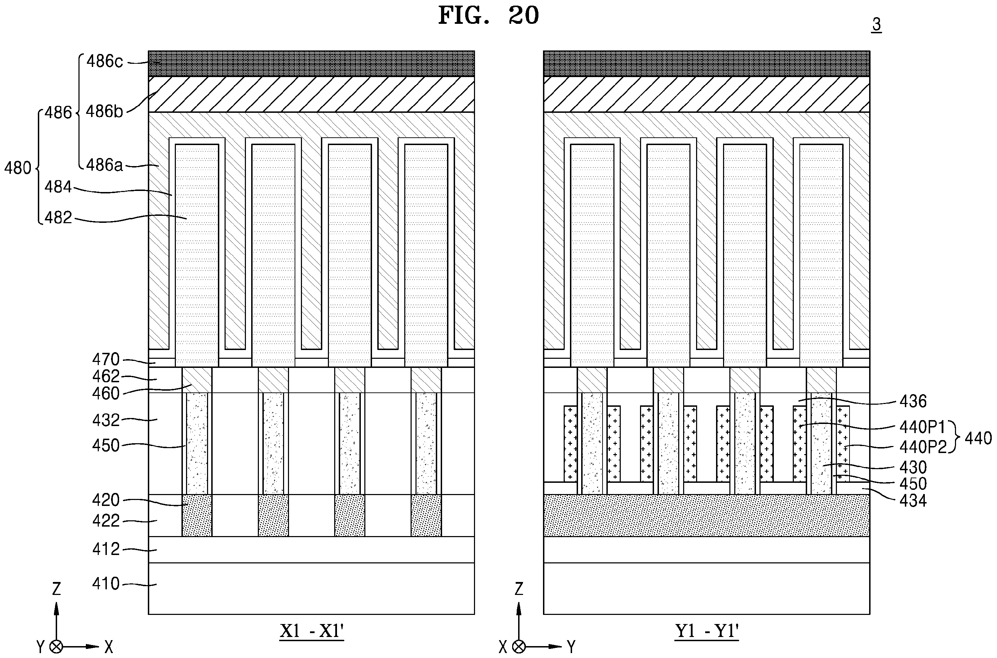

FIG. 19 is a layout view illustrating a semiconductor memory device 3 according to example embodiments, and FIG. 20 is a cross-sectional view taken along line X1-X1' and line Y1-Y1' of FIG. 19.

Referring to FIGS. 19 and 20, the semiconductor memory device 3 may include a substrate 410, a plurality of first conductive lines 420, a channel layer 430, a gate electrode 440, a gate insulation layer 450, and a capacitor structure 480. The semiconductor memory device 3 may be a memory device including a vertical channel transistor (VCT). The VCT may have a structure where a channel length of the channel layer 430 extends in the vertical direction (e.g., the third direction or the Z direction) from the substrate 410.

A lower insulation layer 412 may be disposed on the substrate 410, and the plurality of first conductive lines 420 may be apart from one another in the first horizontal direction (e.g., the X direction) and may extend in the second horizontal direction (e.g., the Y direction), on the lower insulation layer 412. A plurality of first insulation patterns 422 may be disposed to fill a space between the plurality of first conductive lines 420, on the lower insulation layer 412. The plurality of first insulation patterns 422 may extend in the second horizontal direction (e.g., the Y direction), and upper surfaces of the plurality of first insulation patterns 422 may be disposed at the same level as upper surfaces of the plurality of first conductive lines 420. For example, the plurality of first insulation patterns 422 and the plurality of first conductive lines 420 may be arranged alternately in the first horizontal direction (e.g., the X direction). The plurality of first conductive lines 420 may function as a bit line of the semiconductor memory device 3.

In embodiments, the plurality of first conductive lines 420 may include, for example, doped polysilicon, metal, conductive metal nitride, conductive metal silicide, conductive metal oxide, and/or a combination thereof. For example, the plurality of first conductive lines 420 may include doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, and/or a combination thereof, but are not limited thereto. The plurality of first conductive lines 420 may each include a single layer or a multilayer of the materials described above. In embodiments, the plurality of first conductive lines 420 may include a two-dimensional (2D) semiconductor material, and for example, the 2D semiconductor material may include graphene, carbon nanotube, and/or a combination thereof.

The channel layer 430 may be arranged in a matrix form where a plurality of channel layers 430 are arranged apart from one another in the first horizontal direction (e.g., the X direction) and the second horizontal direction (e.g., the Y direction), on the plurality of first conductive lines 420. The channel layer 430 may have a first width in the first horizontal direction (e.g., the X direction) and a first height in the third direction (e.g., the Z direction), and the first height may be greater than the first width. For example, the first height may be (about) 2 to 10 times the first width, but is not limited thereto. A lower portion of the channel layer 430 may function as a first source/drain region (not shown), an upper portion of the channel layer 430 may function as a second source/drain region (not shown), and a portion of the channel layer 430 between the first source/drain region and the second source/drain region may function as a channel region (not shown).

In embodiments, the channel layer 430 may include, for example, an oxide semiconductor, and for example, the oxide semiconductor may include InₓGa_{y}Zn_{z}O, InₓGa_{y}Si_{z}O, InₓSn_{y}Zn_{z}O, InₓZn_{y}O, ZnₓO, ZnₓSn_{y}O, ZnₓO_{y}N, ZrₓZn_{y}Sn_{z}O, Sn_{X}O, HfₓIn_{y}Zn_{z}O, GaₓZn_{y}Sn_{z}O, AlₓZn_{y}Sn_{z}O, YbₓGa_{y}Zn_{z}O, InₓGa_{y}O, and/or a combination thereof. The channel layer 430 may include a single layer or a multilayer of the oxide semiconductor. In some embodiments, the material (e.g., the oxide semiconductor) included in the channel layer 430 and/or the channel layer 430 may have bandgap energy which is greater than that of silicon. For example, the channel layer 430 may have bandgap energy of (about) 1.5 eV to (about) 5.6 eV. In some embodiments, the channel layer 430 may have bandgap energy of (about) 2.0 eV to (about) 4.0 eV. For example, the channel layer 430 may be polycrystalline or amorphous, but is not limited thereto. In embodiments, the channel layer 430 may include a 2D semiconductor material, and for example, the 2D semiconductor material may include graphene, carbon nanotube, and/or a combination thereof.

The gate electrode 440 may extend in the first horizontal direction (e.g., the X direction) on both sidewalls (e.g., opposite sidewalls in the second horizontal direction) of the channel layer 430. The gate electrode 440 may include a first sub gate electrode 440P1 facing a first sidewall of the channel layer 430 and a second sub gate electrode 440P2 facing a second sidewall, facing the first sidewall, of the channel layer 430. For example, the first sub gate electrode 440P1 may be on the first sidewall of the channel layer 430, and the second sub gate electrode 440P2 may be on the second sidewall of the channel layer 430. The first and second sidewall of the channel layer 430 may be opposite to each other in the second horizontal direction (e.g., the Y direction). One channel layer 430 may be disposed between the first sub gate electrode 440P1 and the second sub gate electrode 440P2, and thus, the semiconductor memory device 3 may have a dual gate transistor structure. However, the inventive concept is not limited thereto, and the second sub gate electrode 440P2 (or the first sub gate electrode 440P1) may be omitted and only the first sub gate electrode 440P1 (or the second sub gate electrode 440P2) facing the first sidewall (or the second sidewall) of the channel layer 430 may be formed, whereby a single gate transistor structure may be implemented.

The gate electrode 440 may include, for example, doped polysilicon, metal, conductive metal nitride, conductive metal silicide, conductive metal oxide, and/or a combination thereof. For example, the gate electrode 440 may include doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, and/or a combination thereof, but is not limited thereto.

The gate insulation layer 450 may extend around (e.g., surround) a sidewall of the channel layer 430 and may be disposed between the channel layer 430 and the gate electrode 440 (in the second horizontal direction). For example, as illustrated in FIG. 19, all sidewalls of the channel layer 430 may be surrounded by the gate insulation layer 450, and a portion of a sidewall of the gate electrode 440 may contact the gate insulation layer 450. In some embodiments, the gate insulation layer 450 may extend in an extension direction (i.e., the first horizontal direction (e.g., the X direction)) of the gate electrode 440, and only two sidewalls facing the gate electrode 440 among the sidewalls of the channel layer 430 (e.g., the opposite sidewalls of the channel layer 430 in the second horizontal direction) may contact the gate insulation layer 450.

In embodiments, the gate insulation layer 450 may include, for example, a high-k dielectric film, having a dielectric constant which is higher than that of a silicon oxide film, a silicon oxynitride film, a silicon oxide film, and/or a combination thereof. The high-k dielectric film may include, for example, metal oxide and/or metal oxynitride. For example, the high-k dielectric film of the gate insulation layer 450 may include HfO₂, HfSiO, HfSiON, HfTaO, HfTiO, HfZrO, ZrO₂, Al₂O₃, and/or a combination thereof, but is not limited thereto.

A plurality of second insulation patterns 432 may extend in the second horizontal direction (e.g., the Y direction) on a plurality of first insulation patterns 422, and the channel layer 430 may be disposed between two adjacent second insulation patterns 432 of the plurality of second insulation patterns 432. Also, a first buried layer 434 and a second buried layer 436 may be disposed in a space between two adjacent channel layers 430, between two adjacent second insulation patterns 432. The first buried layer 434 may be disposed at a lower portion of a space between two adjacent channel layers 430, and the second buried layer 436 may be formed to be disposed in (e.g., at least partially fill) the other portion of the space between the two adjacent channel layers 430, on the first buried layer 434. An upper surface of the second buried layer 436 may be disposed at the same level as an upper surface of the channel layer 430, and the second buried layer 436 may be on (e.g., cover or overlap in the third direction) an upper surface of the gate electrode 440. In some embodiments, the plurality of second insulation patterns 432 may include a material layer which is continued to the plurality of first insulation patterns 422, or the second buried layer 436 may include a material layer continuing with the first buried layer 434. For example, each of the plurality of second insulation patterns 432 and corresponding one of the plurality of first insulation patterns 422 may form a unitary structure. For example, the second buried layer 436 and the first buried layer 434 may form a unitary structure.

A capacitor contact 460 may be disposed on the channel layer 430. The capacitor contact 460 may be disposed to overlap the channel layer 430 (in the third direction (e.g., the Z direction)) and may be arranged in a matrix form where a plurality of capacitor contacts 460 are arranged apart from one another in the first horizontal direction (e.g., the X direction) and the second horizontal direction (e.g., the Y direction). The capacitor contact 460 may include, for example, doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, and/or a combination thereof, but is not limited thereto. An upper insulation layer 462 may extend around (e.g., surround) a sidewall of the capacitor contact 460, on the plurality of second insulation pattern 432 and the second buried layer 436.

An etch stop layer 470 may be disposed on the upper insulation layer 462, and a capacitor structure 480 may be disposed on the etch stop layer 470. The capacitor structure 480 may include a lower electrode 482, a capacitor dielectric layer 484, and an upper electrode 486.

The lower electrode 482 may extend in (e.g., pass through) the etch stop layer 470 and may be electrically connected to (an upper surface of) the capacitor contact 460. The lower electrode 482 may be formed as a pillar shape (a pillar type) which extends in the third direction (e.g., the Z direction), but is not limited thereto. In embodiments, the lower electrode 482 may be disposed to overlap the capacitor contact 460 (in the third direction) and may be arranged in a matrix form where a plurality of lower electrodes 482 are arranged apart from one another in the first horizontal direction (e.g., the X direction) and the second horizontal direction (e.g., the Y direction). In some embodiments, a landing pad (not shown) may be further disposed between the capacitor contact 460 and the lower electrode 482, and the lower electrode 482 may be arranged in a hexagonal shape.

The lower electrode 482 and the capacitor dielectric layer 484 may be the lower electrode 210 and the capacitor dielectric layer 220 each illustrated in FIGS. 10A to 18, and the upper electrode 486 may be the upper electrode 230 illustrated in FIGS. 12A to 18.

The upper electrode 486 may have a stack structure of a first upper electrode layer 486a, a second upper electrode layer 486b, and a third upper electrode layer 486c. The first upper electrode layer 486a, the second upper electrode layer 486b, and the third upper electrode layer 486c may be the first upper electrode layer 232, the second upper electrode layer 234, and the third upper electrode layer 236 each illustrated in FIGS. 12A to 18. The first upper electrode layer 486a and the third upper electrode layer 486c may include, for example, a semiconductor material, and the second upper electrode layer 486b may include, for example, a metal-group material. For example, the first upper electrode layer 486a and the third upper electrode layer 486c may include SiGe, and the second upper electrode layer 486b may include W.

The semiconductor memory device 3 may further include a second wiring contact plug MC2 and one of the first wiring contact plugs MC1 and MC1a illustrated in FIGS. 16A and 18.

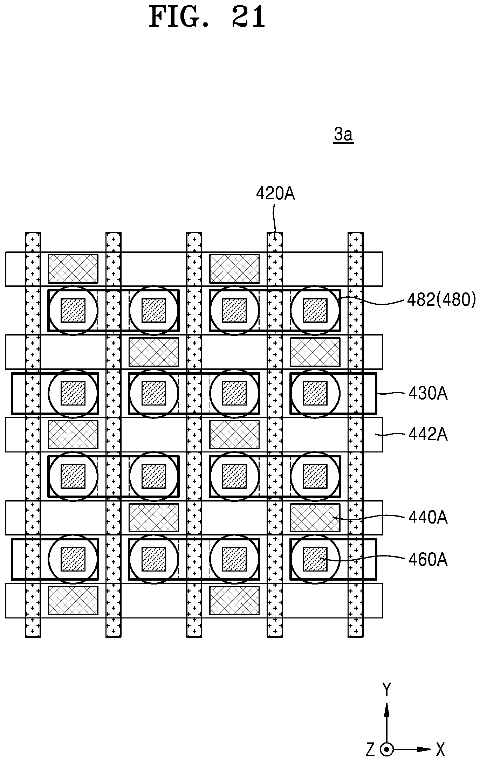

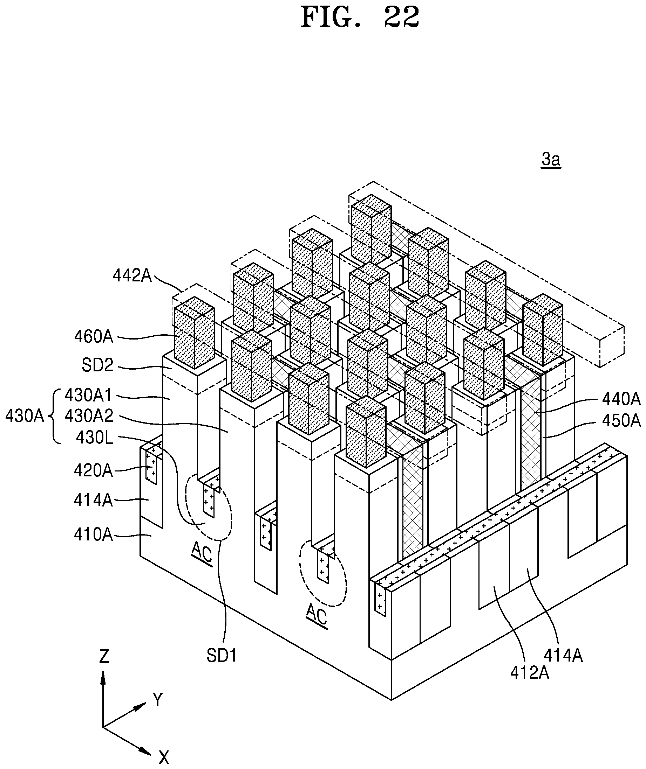

FIG. 21 is a layout view illustrating a semiconductor memory device 3a according to example embodiments, and FIG. 22 is a perspective view illustrating the semiconductor memory device 3a according to example embodiments.

Referring to FIGS. 21 and 22, the semiconductor memory device 3a may include a substrate 410A, a plurality of first conductive lines 420A, a channel structure 430A, a contact gate electrode 440A, a plurality of second conductive lines 442A, and a capacitor structure 480. The semiconductor memory device 3a may be a memory device including a VCT.

A plurality of active regions AC may be defined by a first device isolation layer 412A and a second device isolation layer 414A, on the substrate 410A. The channel structure 430A may be disposed in each of the active regions AC, and the channel structure 430A may include a first active pillar 430A1 and a second active pillar 430A2, each extending in the vertical direction, and a connection portion 430L connected to a lower portion of the first active pillar 430A1 and a lower portion of the second active pillar 430A2. A first source/drain region SD1 may be disposed in the connection portion 430L, and a second source/drain region SD2 may be disposed in an upper portion of each of the first and second active pillars 430A1 and 430A2. Each of the first active pillar 430A1 and the second active pillar 430A2 may configure an independent unit memory cell.

The plurality of first conductive lines 420A may extend in a direction intersecting with each of the plurality of active regions AC, and for example, may extend in the second horizontal direction (e.g., the Y direction). One of the plurality of first conductive lines 420A may be disposed on the connection portion 430L between the first active pillar 430A1 and the second active pillar 430A2, and the one first conductive line 420A may be disposed on the first source/drain region SD1. The other first conductive line 420A adjacent to the one first conductive line 420A may be disposed between two (adjacent) channel structures 430A. One of the plurality of first conductive lines 420A may function as a common bit line included in two unit memory cells configured with the first active pillar 430A1 and the second active pillar 430A2 disposed at both sides (opposite sides in the first horizontal direction) of the one first conductive line 420A.

One contact gate electrode 440A may be disposed between two channel structures 430A adjacent to each other in the second horizontal direction (e.g., the Y direction). For example, a contact gate electrode 440A may be disposed between the first active pillar 430A1 included in one channel structure 430A and the second active pillar 430A2 of the channel structure 430A adjacent thereto, and one contact gate electrode 440A may be shared by the first active pillar 430A1 and the second active pillar 430A2 disposed on both sidewalls (e.g., opposite sidewalls in the second horizontal direction) thereof. A gate insulation layer 450A may be disposed between the contact gate electrode 440A and the first active pillar 430A1 and between the contact gate electrode 440A and the second active pillar 430A2. The plurality of second conductive lines 442A may extend in the first horizontal direction (e.g., the X direction) on an upper surface of the contact gate electrode 440A. The plurality of second conductive lines 442A may function as a word line of the semiconductor memory device 3a.

A capacitor contact 460A may be disposed on the channel structure 430A. The capacitor contact 460A may be disposed on the second source/drain region SD2, and a capacitor structure 480 may be disposed on the capacitor contact 460A.

The capacitor structure 480 may be the capacitor structure 200 described above with reference to FIGS. 12A to 18, and the capacitor structure 480 may include the upper electrode 230 illustrated in FIGS. 12A to 18.

The semiconductor memory device 3a may further include a second wiring contact plug MC2 and one of the first wiring contact plugs MC1 and MC1a illustrated in FIGS. 16A and 18.

Hereinabove, example embodiments have been described in the drawings and the specification. Embodiments have been described by using the terms described herein, but this has been merely used for describing the inventive concept and has not been used for limiting a meaning or limiting the scope of the inventive concept defined in the following claims. Therefore, it may be understood by those of ordinary skill in the art that various modifications and other equivalent embodiments may be implemented from the inventive concept. Accordingly, the scope of the inventive concept may be defined based on the scope of the following claims.

While the inventive concept has been particularly shown and described with reference to embodiments thereof, it will be understood that various changes in form and details may be made therein without departing from the scope of the following claims.

## Claims

1. A semiconductor memory device comprising:
a substrate;
a capacitor structure that includes a lower electrode on the substrate, a capacitor dielectric layer on the lower electrode, and an upper electrode on the capacitor dielectric layer;
a charge insulation layer on the capacitor structure; and
a wiring contact plug that extends in the charge insulation layer and is electrically connected to the upper electrode,
wherein the upper electrode includes a first upper electrode layer on the capacitor dielectric layer, a second upper electrode layer on the first upper electrode layer, and a third upper electrode layer on the second upper electrode layer, and
wherein the first upper electrode layer includes a first semiconductor material, the second upper electrode layer includes a metal-group material, and the third upper electrode layer includes a second semiconductor material.

2. The semiconductor memory device of claim 1, wherein the charge insulation layer includes a buried insulation layer and a cover insulation layer on the buried insulation layer, and
an upper surface of the buried insulation layer and an uppermost surface of the third upper electrode layer are coplanar with each other.

3. The semiconductor memory device of claim 2, wherein a lower surface of the cover insulation layer is in contact with the uppermost surface of the third upper electrode layer.

4. The semiconductor memory device of claim 2 or 3, wherein a side surface of the buried insulation layer is in contact with each of the first upper electrode layer, the second upper electrode layer, and the third upper electrode layer.

5. The semiconductor memory device of any preceding claim, wherein the first upper electrode layer has a first thickness in a vertical direction from an upper surface of the capacitor dielectric layer, the second upper electrode layer has a second thickness in the vertical direction, and the third upper electrode layer has a third thickness in the vertical direction,
wherein the vertical direction is perpendicular to a lower surface of the substrate, and
wherein the third thickness is less than the second thickness.

6. The semiconductor memory device of any preceding claim, wherein each of the first semiconductor material and the second semiconductor material includes silicon germanium, and
wherein the metal-group material includes tungsten.

7. The semiconductor memory device of any preceding claim, further comprising:
a wiring line on the charge insulation layer,
wherein the wiring contact plug is in contact with the third upper electrode layer and spaced apart from the second upper electrode layer, and
wherein the wiring line is electrically connected to the upper electrode through the wiring contact plug.

8. The semiconductor memory device of any of claims 1 to 7, further comprising:
a wiring line on the charge insulation layer,
wherein the wiring contact plug is in contact with the second upper electrode layer and the third upper electrode layer,
wherein the wiring contact plug is spaced apart from the first upper electrode layer, and
wherein the wiring line is electrically connected to the upper electrode through the wiring contact plug.

9. A semiconductor memory device comprising:
a substrate including a memory cell region, wherein the memory cell region includes a plurality of active regions;
a plurality of word lines extending in a first horizontal direction, wherein the plurality of word lines overlaps the plurality of active regions in a vertical direction;
a plurality of bit lines on the plurality of active regions, wherein the plurality of bit lines extends in a second horizontal direction that is perpendicular to the first horizontal direction;
a plurality of buried contacts, wherein each of the plurality of buried contacts is in contact with a corresponding one of the plurality of active regions and is in a lower portion of a space between adjacent bit lines among the plurality of bit lines;
a plurality of landing pads, wherein each of the plurality of landing pads is in an upper portion of the space between the adjacent bit lines among the plurality of bit lines and overlaps one of the adjacent bit lines among the plurality of bit lines in the vertical direction;
a plurality of capacitor structures including a plurality of lower electrodes that are electrically connected to the plurality of landing pads, respectively, a capacitor dielectric layer on the plurality of lower electrodes, and an upper electrode on the capacitor dielectric layer; and
a charge insulation layer on the plurality of capacitor structures,
wherein the first horizontal direction and the second horizontal direction are parallel with a lower surface of the substrate,
wherein the vertical direction is perpendicular to the lower surface of the substrate,
wherein the upper electrode includes a first upper electrode layer on the capacitor dielectric layer, a second upper electrode layer on the first upper electrode layer, and a third upper electrode layer on the second upper electrode layer,
wherein the first upper electrode layer includes a semiconductor material,
wherein the second upper electrode layer includes a metal, and
wherein the third upper electrode layer includes the semiconductor material.

10. The semiconductor memory device of claim 9, wherein the first upper electrode layer has a first thickness in the vertical direction from an uppermost end of the capacitor dielectric layer, the second upper electrode layer has a second thickness in the vertical direction, and the third upper electrode layer has a third thickness in the vertical direction,
wherein the second thickness is greater than or equal to the first thickness, and
wherein the third thickness is less than the second thickness.

11. The semiconductor memory device of claim 10, wherein the third thickness is less than or equal to the first thickness when the second thickness is greater than the first thickness, and
wherein the third thickness is less than the first thickness when the second thickness is equal to the first thickness.

12. The semiconductor memory device of any of claims 9 to 11, wherein the charge insulation layer comprises:
a buried insulation layer; and
a cover insulation layer on the buried insulation layer,
wherein the buried insulation layer is disposed lower than or equal to an uppermost end of the third upper electrode layer in the vertical direction,
wherein the cover insulation layer is disposed higher than or equal to the uppermost end of the third upper electrode layer in the vertical direction, and
wherein a lower surface of the cover insulation layer is in direct contact with an uppermost surface of the third upper electrode layer.

13. The semiconductor memory device of claim 12, wherein a side surface of the buried insulation layer is in contact with each of the first upper electrode layer, the second upper electrode layer, and the third upper electrode layer, and
an upper surface of the buried insulation layer is in contact with the lower surface of the cover insulation layer.

14. A semiconductor memory device comprising:
a substrate including a memory cell region and a periphery region, wherein the memory cell region includes a plurality of active regions, and the periphery region includes at least one logic active region;
a gate line on the at least one logic active region;
a logic bit line on the gate line;
a plurality of word lines extending in a first horizontal direction, wherein the plurality of word lines overlaps the plurality of active regions in a vertical direction;
a plurality of bit lines on the plurality of active regions, wherein the plurality of bit lines extends in a second horizontal direction that is perpendicular to the first horizontal direction;
a plurality of buried contacts that is in contact with the plurality of active regions, and wherein one of the plurality of buried contacts is in a lower portion of a space between adjacent bit lines among the plurality of bit lines;
a plurality of landing pads, wherein one of the plurality of landing pads is in an upper portion of the space between the adjacent bit lines among the plurality of bit lines and overlaps one of the adjacent bit lines among the plurality of bit lines in the vertical direction, and wherein at least a portion of each of the plurality of landing pads is at a same height as the logic bit line in the vertical direction;
a plurality of capacitor structures including a plurality of lower electrodes that are electrically connected to the plurality of landing pads, respectively, a capacitor dielectric layer on the plurality of lower electrodes, and an upper electrode on the capacitor dielectric layer;
a charge insulation layer on the logic bit line and the plurality of capacitor structures;
a plurality of wiring lines on the charge insulation layer;
a first wiring contact plug that extends in the charge insulation layer, wherein a first wiring line of the plurality of wiring lines is electrically connected to the upper electrode through the first wiring contact plug; and
a second wiring contact plug that extends in the charge insulation layer, wherein a second wiring line of the plurality of wiring lines is electrically connected to the logic bit line through the second wiring contact plug,
wherein the upper electrode includes a first upper electrode layer on the capacitor dielectric layer, a second upper electrode layer on the first upper electrode layer, and a third upper electrode layer on the second upper electrode layer,
wherein the first upper electrode layer includes poly silicon germanium,
wherein the second upper electrode layer includes tungsten,
wherein the third upper electrode layer includes poly silicon germanium,
wherein the first horizontal direction and the second horizontal direction are parallel with a lower surface of the substrate, and
wherein the vertical direction is perpendicular to the lower surface of the substrate.

15. The semiconductor memory device of claim 14, wherein the charge insulation layer includes a buried insulation layer and a cover insulation layer on the buried insulation layer,
wherein the buried insulation layer is disposed lower than or equal to an uppermost end of the third upper electrode layer in the vertical direction,
wherein the cover insulation layer is disposed higher than or equal to the uppermost end of the third upper electrode layer in the vertical direction,
wherein a lower surface of the cover insulation layer is in contact with an uppermost surface of the third upper electrode layer and an upper surface of the buried insulation layer,
wherein the upper surface of the buried insulation layer and the uppermost surface of the third upper electrode layer are coplanar with each other, and
wherein a side surface of the buried insulation layer is in contact with each of the first upper electrode layer, the second upper electrode layer, and the third upper electrode layer.
